(19)

Europäisches Patentamt
European Patent Office
Office européen des brevets

(11) **EP 4 539 370 A1**

(12) **EUROPEAN PATENT APPLICATION**
published in accordance with Art. 153(4) EPC

(43) Date of publication:
**16.04.2025 Bulletin 2025/16**

(21) Application number: **23830187.3**

(22) Date of filing: **26.06.2023**

(51) International Patent Classification (IPC):
***H04L 1/00*** *(2006.01)*

(52) Cooperative Patent Classification (CPC):
**H03M 13/00; H03M 13/11; H04L 1/00**

(86) International application number:
**PCT/CN2023/102418**

(87) International publication number:
**WO 2024/002010 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.07.2022  CN 202210769913
18.10.2022  CN 202211274829
20.10.2022  CN 202211289383
20.03.2023  CN 202310305051**

(71) Applicant: **Huawei Technologies Co., Ltd.
Shenzhen, Guangdong 518129 (CN)**

(72) Inventors:
• **LIN, Wei
Shenzhen, Guangdong 518129 (CN)**
• **QIAN, Bin
Shenzhen, Guangdong 518129 (CN)**
• **YANG, Xun
Shenzhen, Guangdong 518129 (CN)**
• **MONTORSI, Guido
10131 Torino (IT)**
• **BENEDETTO, Sergio
10122 Torino (IT)**

(74) Representative: **Körber, Martin Hans
Mitscherlich PartmbB
Patent- und Rechtsanwälte
Karlstraße 7
80333 München (DE)**

(54) **METHOD FOR DETERMINING LENGTH OF LDPC CODEWORD IN UWB SYSTEM, AND RELATED APPARATUS**

(57)    This application relates to a method for determining a length of an LDPC code word in a UWB system and a related apparatus. The method includes: A communication apparatus determines a length of an LDPC code based on a length of a to-be-encoded information bit. When the length of the information bit ranges from 0 to 324, a 648-bit LDPC code is selected. When the length of the information bit ranges from 325 to 648 or from 973 to 1296, a 1296-bit LDPC code is selected. When the length of the information bit ranges from 649 to 972, a 1944-bit LDPC code is selected. According to embodiments of this application, higher performance gain can be achieved. This application is applied to a UWB-based wireless personal local area network system, sensing system, or the like, including an 802.15 series protocol, such as the 802.15.4ab protocol or a next-generation UWB protocol of the 802.15.4ab protocol; and may be further applied to a wireless local area network system based on an 802.11 series protocol, such as 802.11be or a next-generation protocol of 802.11be, or Wi-Fi 8.

```
                                                    ┌──────────────────────────────────────────────┐  S101
                                                    │ A communication apparatus obtains a length of │
                                                    │ a to-be-encoded information bit                │
                                                    └──────────────────────────────────────────────┘
                                                                         │
                                                                         ▼
                                                    ┌──────────────────────────────────────────────┐
                                                    │ The communication apparatus determines a       │
                                                    │ length of an LDPC code word based on the       │
                                                    │ length of the to-be-encoded information bit,   │
                                                    │ where a parity-check matrix corresponding to   │
                                                    │ the LDPC code word is used to encode the       │
                                                    │ to-be-encoded information bit to generate a    │  S102
                                                    │ parity bit; and if the length of the           │
                                                    │ to-be-encoded information bit is greater than  │
                                                    │ 0 and less than or equal to 324 bits, the      │
                                                    │ length of the LDPC code word is 648 bits; if   │
                                                    │ the length of the to-be-encoded information    │
                                                    │ bit is greater than 324 bits and less than or  │
                                                    │ equal to 648 bits, the length of the LDPC code │
                                                    │ word is 1296 bits; if the length of the        │
                                                    │ to-be-encoded information bit is greater than  │
                                                    │ 648 bits and less than or equal to 972 bits,   │
                                                    │ the length of the LDPC code word is 1944       │
                                                    │ bits; or if the length of the to-be-encoded    │
                                                    │ information bit is greater than 972 bits and   │
                                                    │ less than or equal to 1296 bits, the length of │
                                                    │ the LDPC code word is 1296 bits                │
                                                    └──────────────────────────────────────────────┘
```

FIG. 7

**EP 4 539 370 A1**

## Description

This application claims priorities to Chinese Patent Application No. 202210769913.4, filed with the China National Intellectual Property Administration on July 1, 2022 and entitled "METHOD FOR DETERMINING LENGTH OF LDPC CODE WORD IN UWB SYSTEM AND RELATED APPARATUS", to Chinese Patent Application No. 202211274829.1, filed with the China National Intellectual Property Administration on October 18, 2022 and entitled "METHOD FOR DETERMINING LENGTH OF LDPC CODE WORD IN UWB SYSTEM AND RELATED APPARATUS", to Chinese Patent Application No. 202211289383.X, filed with the China National Intellectual Property Administration on October 20, 2022 and entitled "METHOD FOR DETERMINING LENGTH OF LDPC CODE WORD IN UWB SYSTEM AND RELATED APPARATUS", and to Chinese Patent Application No. 202310305051.4, filed with the China National Intellectual Property Administration on March 20, 2023 and entitled "METHOD FOR DETERMINING LENGTH OF LDPC CODE WORD IN UWB SYSTEM AND RELATED APPARATUS", all of which are incorporated herein by reference in their entireties.

## TECHNICAL FIELD

This application relates to the field of communication technologies, and in particular, to a method for determining a length of a low-density parity-check (low-density parity-check, LDPC) code word in an ultra-wideband (ultra-wideband, UWB) system and a related apparatus.

## BACKGROUND

Wireless local area network (wireless local area network, WLAN) standards, such as Institute of Electrical and Electronics Engineers (institute of electrical and electronics engineers, IEEE) 802.11n/ac/ax/be, mainly study how to improve user experience in a 60-GHz high-bandwidth scenario, including increasing an average user throughput and improving energy utilization of a battery-based power supply device. To implement this, high-speed and reliable transmission of services, such as data and video services, needs to be implemented on limited frequency resources and power resources. Therefore, a highly reliable and efficient channel encoding and decoding scheme is needed.

Currently, a turbo code and an LDPC code are two most commonly used channel coding schemes in the channel coding field, and both have performance close to a Shannon (Shannon) limit, and have been widely used in the communication field. Compared with the turbo code, the LDPC code has significant advantages. For example, quite good bit error performance can be achieved without deep interleaving, better frame error rate performance is achieved, an error floor (error floor) is greatly lowered, parallel decoding is supported, and a decoding delay is short. Therefore, the LDPC code has become a standard channel coding scheme for low-frequency short-range WLAN communication systems such as 802.11n/ac/ax systems.

To improve transmission reliability of a wireless transmission system, the LDPC code is widely used in WLAN standards. In a next-generation UWB standard such as the IEEE 802.15ab standard, the LDPC code used in a WLAN is to be introduced to improve data transmission reliability of a system. However, selection of a length of an LDPC code word affects error control performance. Therefore, how to determine a length of an LDPC code word in a UWB system urgently needs to be studied.

## SUMMARY

Embodiments of this application provide a method for determining a length of an LDPC code word in a UWB system and a related apparatus, to achieve higher error control performance gain and reduce bit rate loss.

The following describes this application from different aspects. It should be understood that mutual reference may be made between the following different aspects in terms of implementations and beneficial effect.

According to a first aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes one or more of the following cases: If the length of the to-be-encoded information bit is greater than 0 and less than or equal to 324 bits, the communication apparatus determines that the length of the LDPC code word is 648 bits. If the length of the to-be-encoded information bit is greater than 324 bits and less than or equal to 648 bits, the communication apparatus determines that the length of the LDPC code word is 1296 bits. If the length of the to-be-encoded information bit is greater than 648 bits and less than or equal to 972 bits, the communication apparatus determines that the length of the LDPC code word is 1944 bits. If the length of the to-be-encoded information bit is greater than 972 bits and less than or equal to 1296 bits, the communication apparatus determines that the length of the LDPC code word is 1296 bits.

For detailed analysis of beneficial effect of this application, refer to descriptions in the following method embodiments. Details are not described herein. In this application, higher error control performance gain can be achieved, and bit rate loss can be reduced.

In this application, the to-be-encoded information bit is an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

With reference to the first aspect, in a possible implementation, that the communication apparatus determines a length of an LDPC code word based on the length of the to-be-encoded information bit further includes: If the length of the to-be-encoded information bit is greater than 1296 bits, the communication apparatus determines that the length of the LDPC code word is 1944 bits.

With reference to the first aspect, in a possible implementation, that the communication apparatus determines a length of an LDPC code word based on the length of the to-be-encoded information bit further includes one or more of the following cases: If the length of the to-be-encoded information bit is greater than 1296 bits and less than or equal to 1620 bits, the communication apparatus determines that the length of the LDPC code word is 648 bits. If the length of the to-be-encoded information bit is greater than 1620 bits and less than or equal to 1944 bits, the communication apparatus determines that the length of the LDPC code word is 1944 bits. If the length of the to-be-encoded information bit is greater than 1944 bits and less than or equal to 2592 bits, the communication apparatus determines that the length of the LDPC code word is 1296 bits. If the length of the to-be-encoded information bit is greater than 2592 bits, the communication apparatus determines that the length of the LDPC code word is 1944 bits.

With reference to the first aspect, in a possible implementation, the method further includes: The communication apparatus transmits the LDPC code word, where the LDPC code word includes the to-be-encoded information bit and the parity bit. For example, the communication apparatus generates the LDPC code word based on the determined length of the LDPC code word, the to-be-encoded information bit, a reference bit rate of the LDPC code word, and other information, and transmits the LDPC code word.

With reference to the first aspect, in a possible implementation, the reference bit rate of the LDPC code word is 1/2.

With reference to the first aspect, in a possible implementation, a quantity of shortening zero bits in the LDPC code word is determined based on the length of the to-be-encoded information bit and a quantity of information bits in the LDPC code word. The quantity of information bits in the LDPC code word is determined based on the length of the LDPC code word and the reference bit rate.

For example, the quantity of shortening zero bits in the LDPC code word is as follows:

$$Padding\_Num = mod(K - mod(Inf\_Num, K), K),$$

where
Padding_Num indicates the quantity of shortening zero bits in the LDPC code word, K indicates a quantity of information bits in the LDPC code word, Inf_Num indicates the length of the to-be-encoded information bit, mod indicates a modulo operation, $K = N \times R$, N indicates the length of the LDPC code word, and R indicates the reference bit rate of the LDPC code word.

According to a second aspect, this application provides a communication apparatus, including an obtaining unit and a determining unit. The obtaining unit is configured to obtain a length of a to-be-encoded information bit. The determining unit is configured to determine a length of a low-density parity-check LDPC code word based on the length of the to-be-encoded information bit, where a parity-check matrix corresponding to the LDPC code word is used to encode the to-be-encoded information bit to generate a parity bit. The determining unit is specifically configured to perform one or more of the following operations: when the length of the to-be-encoded information bit is greater than 0 and less than or equal to 324 bits, determining that the length of the LDPC code word is 648 bits; when the length of the to-be-encoded information bit is greater than 324 bits and less than or equal to 648 bits, determining that the length of the LDPC code word is 1296 bits; when the length of the to-be-encoded information bit is greater than 648 bits and less than or equal to 972 bits, determining that the length of the LDPC code word is 1944 bits; or when the length of the to-be-encoded information bit is greater than 972 bits and less than or equal to 1296 bits, determining that the length of the LDPC code word is 1296 bits.

In this application, the to-be-encoded information bit is an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

With reference to the second aspect, in a possible implementation, the determining unit is further configured to:

when the length of the to-be-encoded information bit is greater than 1296 bits, determine that the length of the LDPC code word is 1944 bits.

With reference to the second aspect, in a possible implementation, the determining unit is further configured to perform one or more of the following operations: when the length of the to-be-encoded information bit is greater than 1296 bits and less than or equal to 1620 bits, determining that the length of the LDPC code word is 648 bits; when the length of the to-be-encoded information bit is greater than 1620 bits and less than or equal to 1944 bits, determining that the length of the LDPC code word is 1944 bits; when the length of the to-be-encoded information bit is greater than 1944 bits and less than or equal to 2592 bits, determining that the length of the LDPC code word is 1296 bits; or when the length of the to-be-encoded information bit is greater than 2592 bits, determining that the length of the LDPC code word is 1944 bits.

With reference to the second aspect, in a possible implementation, the communication apparatus further includes a transmission unit, configured to transmit the LDPC code word, where the LDPC code word includes the to-be-encoded information bit and the parity bit.

With reference to the second aspect, in a possible implementation, a reference bit rate of the LDPC code word is 1/2.

With reference to the second aspect, in a possible implementation, a quantity of shortening zero bits in the LDPC code word is determined based on the length of the to-be-encoded information bit and a quantity of information bits in the LDPC code word. The quantity of information bits in the LDPC code word is determined based on the length of the LDPC code word and the reference bit rate.

For example, the quantity of shortening zero bits in the LDPC code word is as follows:

$$\text{Padding\_Num} = \text{mod}(K - \text{mod}(\text{Inf\_Num}, K), K),$$

where
Padding_Num indicates the quantity of shortening zero bits in the LDPC code word, K indicates a quantity of information bits in the LDPC code word, Inf_Num indicates the length of the to-be-encoded information bit, mod indicates a modulo operation, $K = N \times R$, N indicates the length of the LDPC code word, and R indicates the reference bit rate of the LDPC code word.

According to a third aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes: If the length of the to-be-encoded information bit is greater than 1296 bits, the communication apparatus determines that the length of the LDPC code word is 1944 bits.

According to a fourth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes one or more of the following cases: If the length of the to-be-encoded information bit is greater than 1296 bits and less than or equal to 1620 bits, the communication apparatus determines that the length of the LDPC code word is 648 bits. If the length of the to-be-encoded information bit is greater than 1620 bits and less than or equal to 1944 bits, the communication apparatus determines that the length of the LDPC code word is 1944 bits. If the length of the to-be-encoded information bit is greater than 1944 bits and less than or equal to 2592 bits, the communication apparatus determines that the length of the LDPC code word is 1296 bits. If the length of the to-be-encoded information bit is greater than 2592 bits, the communication apparatus determines that the length of the LDPC code word is 1944 bits.

According to a fifth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes: If the length of the to-be-encoded information bit is greater than 972 bits and less than or equal to 1296 bits, the communication apparatus determines that the length of the LDPC code word is 1296 bits.

According to a sixth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes one or more of the following cases: If the length of the to-be-encoded information bit is greater than 0 and less than or equal to 324 bits, the communication apparatus determines that the length of the LDPC code word is 648 bits. If the length of the to-be-encoded information bit is greater than 324 bits and less than or equal to 648 bits, the communication apparatus determines that the length of the LDPC code word is 1296 bits. If the length of the to-be-encoded information bit is greater than 648 bits and less than or equal to 972 bits, the communication apparatus determines that the length of the LDPC code word is 648 bits.

In this application, higher error control performance gain can be achieved, and bit rate loss can be reduced. In addition, only LDPC codes with short and medium code lengths (to be specific, LDPC codes with code lengths of 648 bits and 1296 bits) in a WLAN are used, to reduce power consumption in a UWB system.

In this application, the to-be-encoded information bit is an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

With reference to the sixth aspect, in a possible implementation, that the communication apparatus determines a length of an LDPC code word based on the length of the to-be-encoded information bit further includes: If the length of the to-be-encoded information bit is greater than 972 bits, the communication apparatus determines that the length of the LDPC code word is 1296 bits.

With reference to the sixth aspect, in a possible implementation, that the communication apparatus determines a length of an LDPC code word based on the length of the to-be-encoded information bit further includes one or more of the following cases: If the length of the to-be-encoded information bit is greater than 972 bits and less than or equal to 1296 bits, the communication apparatus determines that the length of the LDPC code word is 1296 bits. If the length of the to-be-encoded information bit is greater than 1296 bits and less than or equal to 1620 bits, the communication apparatus determines that the length of the LDPC code word is 648 bits. If the length of the to-be-encoded information bit is greater than 1620 bits, the communication apparatus determines that the length of the LDPC code word is 1296 bits.

With reference to the sixth aspect, in a possible implementation, the method further includes: The communication apparatus transmits the LDPC code word, where the LDPC code word includes the to-be-encoded information bit and the parity bit. For example, the communication apparatus generates the LDPC code word based on the determined length of the LDPC code word, the to-be-encoded information bit, a reference bit rate of the LDPC code word, and other information, and transmits the LDPC code word.

With reference to the sixth aspect, in a possible implementation, the reference bit rate of the LDPC code word is 1/2.

With reference to the sixth aspect, in a possible implementation, a quantity of shortening zero bits in the LDPC code word is determined based on the length of the to-be-encoded information bit and a quantity of information bits in the LDPC code word. The quantity of information bits in the LDPC code word is determined based on the length of the LDPC code word and the reference bit rate.

For example, the quantity of shortening zero bits in the LDPC code word is as follows:

$$\text{Padding\_Num} = \text{mod}(K - \text{mod}(\text{Inf\_Num}, K), K),$$

where
Padding_Num indicates the quantity of shortening zero bits in the LDPC code word, K indicates a quantity of information bits in the LDPC code word, Inf_Num indicates the length of the to-be-encoded information bit, mod indicates a modulo operation, $K = N \times R$, N indicates the length of the LDPC code word, and R indicates the reference bit rate of the LDPC code word.

According to a seventh aspect, this application provides a communication apparatus, including an obtaining unit and a determining unit. The obtaining unit is configured to obtain a length of a to-be-encoded information bit. The determining unit is configured to determine a length of a low-density parity-check LDPC code word based on the length of the to-be-encoded information bit, where a parity-check matrix corresponding to the LDPC code word is used to encode the to-be-encoded information bit to generate a parity bit. The determining unit is specifically configured to perform one or more of the following operations: when the length of the to-be-encoded information bit is greater than 0 and less than or equal to 324 bits, determining that the length of the LDPC code word is 648 bits; when the length of the to-be-encoded information bit is greater than 324 bits and less than or equal to 648 bits, determining that the length of the LDPC code word is 1296 bits; or when the length of the to-be-encoded information bit is greater than 648 bits and less than or equal to 972 bits, determining that the length of the LDPC code word is 648 bits.

In this application, the to-be-encoded information bit is an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

With reference to the seventh aspect, in a possible implementation, the determining unit is further configured to: when the length of the to-be-encoded information bit is greater than 972 bits, determine that the length of the LDPC code word is 1296 bits.

With reference to the seventh aspect, in a possible implementation, the determining unit is further configured to perform one or more of the following operations: when the length of the to-be-encoded information bit is greater than 972 bits and less than or equal to 1296 bits, determining that the length of the LDPC code word is 1296 bits; when the length of the to-be-encoded information bit is greater than 1296 bits and less than or equal to 1620 bits, determining that the length of the LDPC code word is 648 bits; or when the length of the to-be-encoded information bit is greater than 1620 bits, determining that the length of the LDPC code word is 1296 bits.

With reference to the seventh aspect, in a possible implementation, the communication apparatus further includes a transmission unit, configured to transmit the LDPC code word, where the LDPC code word includes the to-be-encoded information bit and the parity bit.

With reference to the seventh aspect, in a possible implementation, a reference bit rate of the LDPC code word is 1/2.

With reference to the seventh aspect, in a possible implementation, a quantity of shortening zero bits in the LDPC code word is determined based on the length of the to-be-encoded information bit and a quantity of information bits in the LDPC code word. The quantity of information bits in the LDPC code word is determined based on the length of the LDPC code word and the reference bit rate.

For example, the quantity of shortening zero bits in the LDPC code word is as follows:

$$\text{Padding\_Num} = \text{mod}(K - \text{mod}(\text{Inf\_Num}, K), K),$$

where

Padding_Num indicates the quantity of shortening zero bits in the LDPC code word, K indicates a quantity of information bits in the LDPC code word, Inf_Num indicates the length of the to-be-encoded information bit, mod indicates a modulo operation, $K = N \times R$, N indicates the length of the LDPC code word, and R indicates the reference bit rate of the LDPC code word.

According to an eighth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes: If the length of the to-be-encoded information bit is greater than 972 bits, the communication apparatus determines that the length of the LDPC code word is 1296 bits.

According to a ninth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes one or more of the following cases: If the length of the to-be-encoded information bit is greater than 972 bits and less than or equal to 1296 bits, the communication apparatus determines that the length of the LDPC code word is 1296 bits. If the length of the to-be-encoded information bit is greater than 1296 bits and less than or equal to 1620 bits, the communication apparatus determines that the length of the LDPC code word is 648 bits. If the length of the to-be-encoded information bit is greater than 1620 bits, the communication apparatus determines that the length of the LDPC code word is 1296 bits.

According to a tenth aspect, this application provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes one or more of the following cases: If the length of the to-be-encoded information bit is greater than 648 bits and less than or equal to 972 bits, the communication apparatus determines that the length of the LDPC code word is 648 bits.

According to an eleventh aspect, this application further provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes: If the length of the to-be-encoded information bit is greater than or equal to 122 bytes and less than or equal to 162 bytes, the communication apparatus determines that the length of the LDPC code word is 1296 bits.

According to a twelfth aspect, this application further provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. That the communication apparatus determines a length of an LDPC code word based on the length of the to-be-encoded information bit includes: If the length of the to-be-encoded information bit is greater than 121 bytes and less than or equal to 162 bytes, the communication apparatus determines that the length of the LDPC code word is 1296 bits.

According to a thirteenth aspect, this application further provides a method for determining a length of an LDPC code word in a UWB system. The method includes: A communication apparatus obtains a length of a to-be-encoded information bit, and determines a length of an LDPC code word based on the length of the to-be-encoded information bit. A parity-check matrix corresponding to the LDPC code word is used to encode the to-be-encoded information bit to generate a parity bit. When the length of the to-be-encoded information bit is greater than 121 bytes and less than or equal to 162 bytes, if a data rate is less than or equal to a preset threshold, the length of the LDPC code word is 1296 bits. When the length of the to-be-encoded information bit is greater than 121 bytes and less than or equal to 162 bytes, if the data rate is greater than the preset threshold, the length of the LDPC code word is 1944 bits.

With reference to the thirteenth aspect, in a possible implementation, the length of the to-be-encoded information bit and the length of the LDPC code word further meet the following condition: If the length of the to-be-encoded information bit is greater than 162 bytes, the length of the LDPC code word is 1944 bits.

With reference to the thirteenth aspect, in a possible implementation, the preset threshold is 1.95 Mbps or 7.8 Mbps.

With reference to the thirteenth aspect, in a possible implementation, the length of the to-be-encoded information bit and the length of the LDPC code word further meet one or more of the following conditions: If the length of the to-be-encoded information bit is greater than 0 and less than or equal to 21 bytes, the length of the LDPC code word is 648 bits. If the length of the to-be-encoded information bit is greater than 21 bytes and less than or equal to 44 bytes, the length of the LDPC code word is 1296 bits. If the length of the to-be-encoded information bit is greater than 44 bytes and less than or equal to 121 bytes, the length of the LDPC code word is 1944 bits.

According to a fourteenth aspect, this application provides a communication apparatus. The communication apparatus includes a processor, configured to perform the method according to any one of the first aspect, the third aspect to the fifth aspect, or the possible implementations of the aspects. Alternatively, the processor is configured to execute a program stored in a memory. When the program is executed, the method according to any one of the sixth aspect, the eighth aspect to the tenth aspect, or the possible implementations of the aspects is performed. Alternatively, the processor is configured to execute a program stored in a memory. When the program is executed, the method according to any one of the eleventh aspect, the twelfth aspect, the thirteenth aspect, or the possible implementations of the aspects is performed.

With reference to the fourteenth aspect, in a possible implementation, the memory is located outside the communication apparatus.

With reference to the fourteenth aspect, in a possible implementation, the memory is located in the communication apparatus.

In embodiments of this application, the processor and the memory may alternatively be integrated into one device. In other words, the processor and the memory may alternatively be integrated together.

With reference to the fourteenth aspect, in a possible implementation, the communication apparatus further includes a transceiver. The transceiver is configured to receive a signal or send a signal.

According to a fifteenth aspect, this application provides a communication apparatus. The communication apparatus includes a logic circuit and an interface, and the logic circuit is coupled to the interface. The logic circuit and the interface may be configured to perform the method according to any one of the first aspect, the third aspect to the fifth aspect, the sixth aspect, the eighth aspect to the thirteenth aspect, or the possible implementations of the aspects.

In a design, the logic circuit is configured to obtain a length of a to-be-encoded information bit, and determine a length of a low-density parity-check LDPC code word based on the length of the to-be-encoded information bit, where a parity-check matrix corresponding to the LDPC code word is used to encode the to-be-encoded information bit to generate a parity bit; and the interface is configured to output the LDPC code word, where the LDPC code word includes the to-be-encoded information bit and the parity bit. The length of the to-be-encoded information bit and the length of the LDPC code word meet one or more of the following conditions: If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 1944 bits. If the length of the to-be-encoded information bit is greater than 972 bits and less than or equal to 1296 bits, the length of the LDPC code word is 1296 bits.

In another design, the logic circuit is configured to: obtain a length of a to-be-encoded information bit, and determine a length of a low-density parity-check LDPC code word based on the length of the to-be-encoded information bit, where a parity-check matrix corresponding to the LDPC code word is used to encode the to-be-encoded information bit to generate a parity bit; and the interface is configured to output the LDPC code word, where the LDPC code word includes the to-be-encoded information bit and the parity bit. The length of the to-be-encoded information bit and the length of the LDPC code word meet one or more of the following conditions: If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 648 bits.

According to a sixteenth aspect, this application provides a computer-readable storage medium. The computer-readable storage medium is configured to store a computer program. When the computer program is run on a computer, the method according to any one of the first aspect, the third aspect to the fifth aspect, the sixth aspect, the eighth aspect to the thirteenth aspect, or the possible implementations of the aspects is performed.

According to a seventeenth aspect, this application provides a computer program product. The computer program product includes a computer program or computer code. When the computer program product is run on a computer, the method according to any one of the first aspect, the third aspect to the fifth aspect, the sixth aspect, the eighth aspect to the thirteenth aspect, or the possible implementations of the aspects is performed.

According to an eighteenth aspect, this application provides a computer program. When the computer program is run on a computer, the method according to any one of the first aspect, the third aspect to the fifth aspect, the sixth aspect, the eighth aspect to the thirteenth aspect, or the possible implementations of the aspects is performed.

During implementation of embodiments of this application, higher error control performance gain can be achieved, and bit rate loss can be reduced.

## BRIEF DESCRIPTION OF DRAWINGS

To describe technical solutions in embodiments of this application more clearly, the following briefly describes accompanying drawings for describing embodiments.

FIG. 1 is a diagram of a structure of a wireless communication system according to an embodiment of this application;

FIG. 2 is a diagram of another structure of a wireless communication system according to an embodiment of this application;

FIG. 3a is a diagram of an LDPC code parity-check matrix according to an embodiment of this application;

FIG. 3b is a Tanner graph of an LDPC code according to an embodiment of this application;

FIG. 4a is a diagram of an LDPC code parity-check matrix with a bit rate of 1/2 and a code length of 648 according to an embodiment of this application;

FIG. 4b is a diagram of a cyclic shift matrix $P_1$ according to an embodiment of this application;

FIG. 5 is a diagram of an LDPC encoding process in a WLAN according to an embodiment of this application;

FIG. 6a is a diagram of an LDPC code parity-check matrix with a bit rate of 1/2 and a code length of 1296 according to an embodiment of this application;

FIG. 6b is a diagram of an LDPC code parity-check matrix with a bit rate of 1/2 and a code length of 1944 according to an embodiment of this application;

FIG. 7 is a schematic flowchart of a method for determining a length of an LDPC code word in a UWB system according to an embodiment of this application;

FIG. 8 is a diagram of an LDPC encoding process in a UWB system according to an embodiment of this application;

FIG. 9 is a diagram of quantities of shortening zero bits for LDPC codes with different code lengths varying with a length of a to-be-encoded information bit according to an embodiment of this application;

FIG. 10 is a diagram of effective bit rates of LDPC codes with different code lengths varying with a length of a to-be-encoded information bit according to an embodiment of this application;

FIG. 11a is a diagram of selecting a length of an LDPC code word according to an embodiment of this application;

FIG. 11b is another diagram of selecting a length of an LDPC code word according to an embodiment of this application;

FIG. 12 is another schematic flowchart of a method for determining a length of an LDPC code word in a UWB system according to an embodiment of this application;

FIG. 13a is still another diagram of selecting a length of an LDPC code word according to an embodiment of this application;

FIG. 13b is yet another diagram of selecting a length of an LDPC code word according to an embodiment of this application;

FIG. 14 is still another schematic flowchart of a method for determining a length of an LDPC code word in a UWB system according to an embodiment of this application;

FIG. 15 is a diagram of a structure of a communication apparatus according to an embodiment of this application;

FIG. 16 is a diagram of a structure of a communication apparatus 1000 according to an embodiment of this application; and

FIG. 17 is a diagram of another structure of a communication apparatus according to an embodiment of this application.

## DESCRIPTION OF EMBODIMENTS

The following clearly and completely describes technical solutions in embodiments of this application with reference to accompanying drawings in embodiments of this application.

In descriptions of this application, "/" indicates "or", unless otherwise specified. For example, A/B may indicate A or B. The term "and/or" in this specification describes only an association relationship between associated objects and indicates that three relationships may exist. For example, A and/or B may represent the following three cases: Only A exists, both A and B exist, and only B exists. In addition, "at least one" means one or more, and "a plurality of" means two or more. "At least one of the following items" or a similar expression thereof indicates any combination of the items, including one of the items or any combination of a plurality of the items. For example, at least one of a, b, or c may indicate a, b, c, a and b, a and c, b and c, or a, b, and c. a, b, and c may be singular or plural.

In addition, the terms "comprise", "include", and any variants thereof are intended to cover a non-exclusive inclusion. For example, a process, a method, a system, a product, a device, or the like that includes a series of steps or units is not limited to the listed steps or units, but optionally further includes steps or units that are not listed, or optionally further includes other steps or units inherent to the process, the method, the product, the device, or the like.

In this application, the term "example", "for example", or the like is used to give an example, an illustration, or a description. Any embodiment or design scheme described with "example", "in an example", or "for example" in this application should not be construed as being more preferred or more advantageous than another embodiment or design scheme. To be precise, the term "example", "in an example", "for example", or the like is intended to present a related concept in a specific manner.

It should be understood that, in this application, "when" and "if" mean that an apparatus performs corresponding processing in an objective case, but are not intended to limit time. The terms do not necessarily mean that the apparatus performs a determining action during implementation, and do not mean any other limitation.

In this application, an element represented in a singular form is intended to indicate "one or more", but not indicate "one and only one", unless otherwise specified.

It should be understood that, in embodiments of this application, determining B based on A does not mean that B is determined only based on A, and B may alternatively be determined based on A and/or other information.

Technical solutions provided in this application are applicable to a wireless personal area network (wireless personal area network, WPAN) based on a UWB technology. For example, a method provided in this application is applicable to an IEEE 802.15 series protocol, for example, an 802.15.4ab protocol or a future generation of UWB WPAN standard. Examples are not listed one by one herein. The method provided in this application may be further applied to various communication systems, such as an internet of things (internet of things, IoT) system, vehicle-to-everything (vehicle to X, V2X), and a narrowband internet of things (narrowband internet of things, NB-IoT) system, or is applied to a device in vehicle-to-everything, an internet of things node, a sensor, or the like in the internet of things (IoT, internet of things), a smart camera, a smart remote control, and a smart water or electricity meter in a smart home, a sensor in a smart city, and the like. The method provided in this application is further applicable to an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a long term evolution (long term evolution, LTE) system, a 5th-generation (5th-generation, 5G) communication system, a 6th-generation (6th-generation, 6G) communication system, and the like.

The UWB technology is a new wireless communication technology. In the UWB technology, data is transmitted through a nanosecond-level non-sinusoidal narrow pulse, and modulation is performed on a pulse with quite steep rise and fall time. Therefore, the UWB technology occupies a quite wide spectrum range, so that a signal has gigahertz (GHz)-level bandwidth. Bandwidth used by UWB is usually greater than 1 GHz. A UWB system does not need to generate a sinusoidal carrier signal and can directly transmit a pulse sequence. Therefore, the UWB system has a quite wide spectrum and quite low average power. A UWB wireless communication system has advantages such as a strong multi-path resolution capability, low power consumption, and high confidentiality. This facilitates coexistence with other systems, and therefore improves spectrum utilization and increases a system capacity. In addition, in a short-range communication application, transmit power of a UWB transmitter may be usually lower than 1 mW (milliwatt). Theoretically, interference caused by a UWB signal is equivalent to only white noise. This facilitates good coexistence between ultra-wideband and existing narrowband communication. Therefore, the UWB system and a narrowband (narrowband, NB) communication system can simultaneously operate without interfering with each other. The method provided in this application may be implemented by a communication apparatus in a wireless communication system. In a communication apparatus, an apparatus or a chip for implementing a function of a UWB system may be referred to as a UWB module, and an apparatus or a chip for implementing a function of a narrowband communication system may be referred to as a narrowband communication module. The UWB module and the narrowband communication module may be different apparatuses or chips. Certainly, the UWB module and the narrowband communication module may alternatively be integrated into one apparatus or chip. Implementations of the UWB module and the narrowband communication module in the communication apparatus are not limited in embodiments of this application. A communication apparatus in this application includes a UWB module, and optionally, further includes a narrowband communication module.

The method provided in this application may be implemented by a communication apparatus in a wireless communication system. The communication apparatus may be an apparatus in a UWB system. For example, the communication apparatus may include but is not limited to a communication server, a router, a switch, a bridge, a computer, a mobile phone, and the like that support the UWB technology. For another example, the communication apparatus may include user equipment (user equipment, UE). The user equipment may include various devices that support the UWB technology, such as a handheld device, a vehicle-mounted device (for example, a vehicle or a component mounted in a vehicle), a wearable device, an internet of things (internet of things, IoT) device, a computing device, or another processing device connected to a wireless modem. Examples are not listed one by one herein. For another example, the communication apparatus may include a central control point, for example, a personal area network (personal area network, PAN) or a PAN coordinator. The PAN coordinator or the PAN may be a mobile phone, a vehicle-mounted device, an anchor (Anchor), a tag (tag), a smart home appliance, or the like. For another example, the communication apparatus may include a chip, and the chip may be disposed in a communication server, a router, a switch, a terminal device, or the like. Examples are not listed one by one herein. It can be understood that the foregoing descriptions about the communication apparatus are applicable to the communication apparatus in this application.

Optionally, the communication apparatus in embodiments of this application may be a device that supports a plurality of WPAN standards, such as IEEE 802.15.4ab that is currently being discussed or a later version.

In embodiments of this application, the communication apparatus may include a hardware layer, an operating system layer running above the hardware layer, and an application layer running above the operating system layer. The hardware layer includes hardware such as a central processing unit (central processing unit, CPU), a memory management unit (memory management unit, MMU), and a memory (also referred to as a main memory). The operating system may be any one or more computer operating systems that implement service processing through a process (process), for example, a Linux operating system, a Unix operating system, an Android operating system, an iOS operating system, or a Windows operating system. The application layer includes applications such as a browser, an address book, word processing software, and instant messaging software. In addition, a specific structure of an entity for performing the method provided in embodiments of this application is not particularly limited in embodiments of this application, provided that the entity can run a program that records code of the method provided in embodiments of this application to perform communication according to the method provided in embodiments of this application.

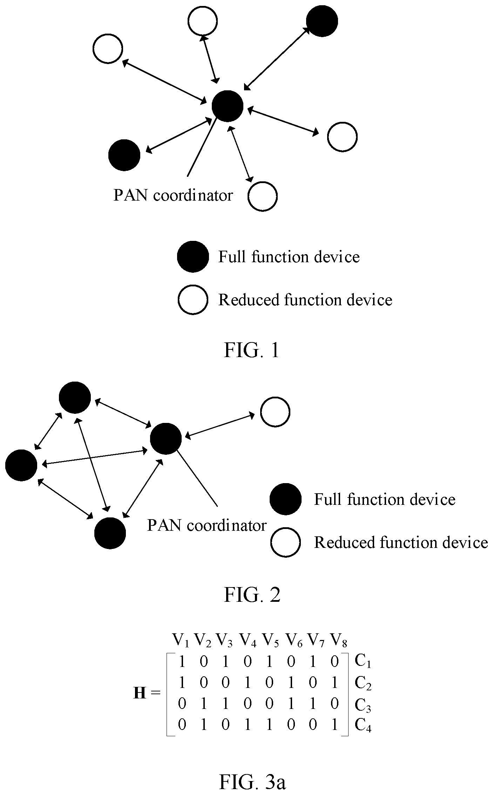

For example, FIG. 1 is a diagram of a structure of a wireless communication system according to an embodiment of this application. As shown in FIG. 1, the wireless communication system has a star topology structure. In this structure, a central control node (for example, a PAN coordinator in FIG. 1) may perform data communication with one or more other devices. FIG. 2 is a diagram of another structure of a wireless communication system according to an embodiment of this application. As shown in FIG. 2, the wireless communication system has a point-to-point topology structure. In this structure, a central control node (for example, a PAN coordinator in FIG. 2) may perform data communication with one or more other devices, and other different devices may also perform data communication with each other. In FIG. 1 and FIG. 2, both a full function device (full function device) and a reduced function device (reduced function device) may be understood as communication apparatuses shown in this application. The full function device is defined relative to the reduced function device. For example, the reduced function device cannot be a PAN coordinator (coordinator). For another example, compared with the full function device, the reduced function device may have no coordination capability or have a lower communication rate than the full function device. It can be understood that the PAN coordinator shown in FIG. 2 is merely an example, and each of other three full function devices shown in FIG. 2 may alternatively serve as a PAN coordinator. Examples are not shown one by one herein. It can be further understood that the full function device and the reduced function device shown in this application are merely example communication apparatuses. Any apparatus capable of implementing a method for determining a length of an LDPC code word in a UWB system in this application falls within the protection scope of this application.

The following briefly describes some related content, terms, or nouns in this application.

1. LDPC code

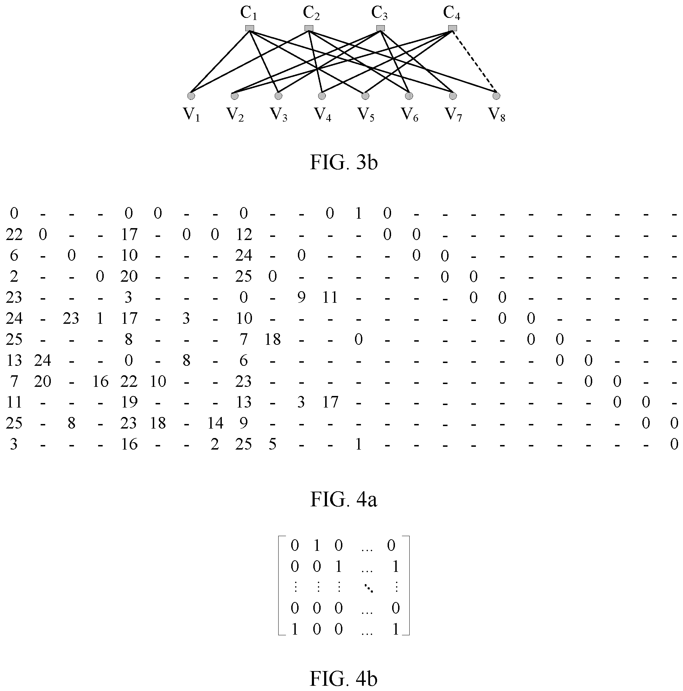

An LDPC code parity-check matrix is a sparse matrix. To be specific, a quantity of non-zero elements in the matrix is far less than a quantity of zero elements, or a ratio of a row weight to a code length and a ratio of a column weight to the code length in the matrix are both quite small values. An LDPC code may be expressed in a graph, and the graph is referred to as a Tanner graph. The Tanner graph is in a one-to-one correspondence with the parity-check matrix, and includes two types of nodes: A first type of node represents a code word symbol, and is referred to as a variable node. A second type of node represents a check constraint relationship, and is referred to as a check node. Each check node represents a check constraint relationship. For example, FIG. 3a is a diagram of an LDPC code parity-check matrix according to an embodiment of this application, and FIG. 3b is a Tanner graph of an LDPC code according to an embodiment of this application. In FIG. 3a and FIG. 3b, $\{V_i\}$ indicates a variable node set, and $\{C_i\}$ indicates a check node set.

An LDPC code used in the 802.11ac/ax standards is a quasi-cyclic LDPC (quasi cyclic LDPC, QC-LDPC) code. The QC-LDPC code is a structured LDPC code that is widely used. A parity-check matrix of the QC-LDPC code has a unique structure, and encoding may be implemented by using a simple feedback shift register. Therefore, a problem of encoding complexity of the LDPC code can be well resolved. FIG. 4a is a diagram of an LDPC code parity-check matrix with a bit rate of 1/2 and a code length of 648 according to an embodiment of this application. As shown in FIG. 4a, each element in the LDPC code parity-check matrix with a code length N of 648 and a bit rate R of 1/2 represents a Z-order matrix (Z = N/24), where "0" indicates a $Z \times Z$ unit matrix, and "-" indicates a $Z \times Z$ all-zero matrix. For example, an element "22" in FIG. 4a indicates that a $Z \times Z$ unit matrix P is cyclically shifted rightward by 22 bits to obtain a cyclic shift matrix $P_{22}$. Other non-zero elements in FIG. 4a are similar to the element "22", and details are not described again. $P_i$ indicates a cyclic shift matrix, and i ($0 \leq i \leq Z - 1$) indicates a cyclic shift value. FIG. 4b is a diagram of a cyclic shift matrix $P_1$ according to an embodiment of this application. As shown in FIG. 4b, the cyclic shift matrix $P_1$ indicates that a $Z \times Z$ unit matrix P is cyclically shifted rightward by one bit.

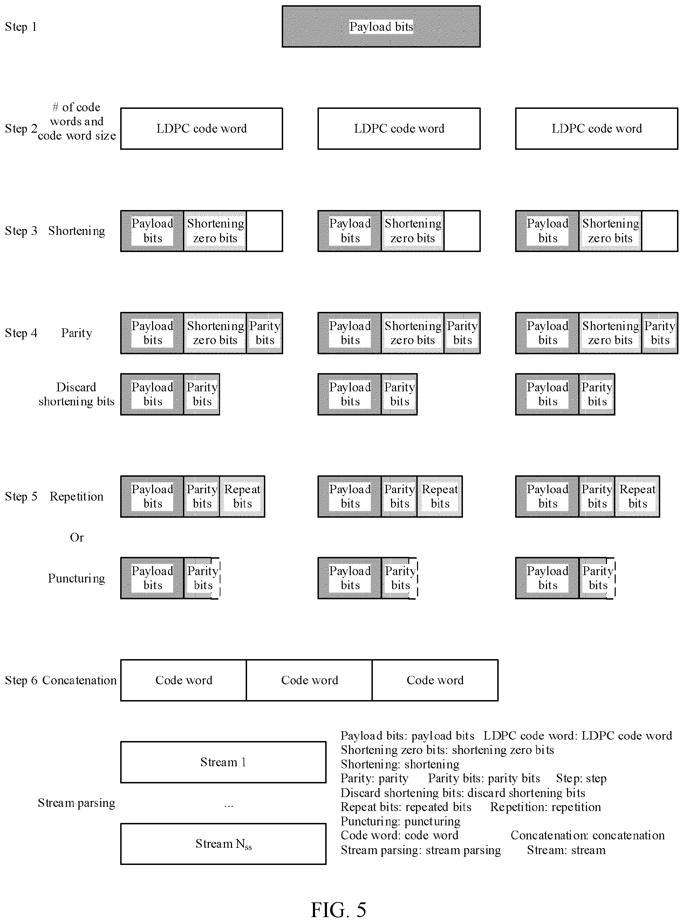

In an existing WLAN standard (for example, 802.11n/ac), an orthogonal frequency division multiplexing (orthogonal frequency division multiplexing, OFDM) technology is used. An LDPC encoding module needs to encode data bits (which may also be understood as payload bits (payload bits)), and then place encoded bits into an integer quantity of OFDM symbols. The encoded bits also need to be able to be exactly placed into an integer quantity of LDPC code words. Therefore, before transmission, a minimum quantity $N_{SYM}$ of OFDM symbols needed for current transmission needs to be calculated. Then a total quantity of coded bits that can be stored in all OFDM symbols is calculated based on $N_{SYM}$ and a current coding and modulation scheme: $N_{TCB} = N_{CBPS} \times N_{SYM}$, where $N_{CBPS}$ indicates a quantity of coded bits that can be stored in each OFDM symbol. Then an LDPC code length $L_{LDPC}$ and a quantity $N_{CW}$ of code words that are used for the current transmission are determined based on the total quantity $N_{TCB}$ of coded bits. However, for most lengths of to-be-encoded data bits and coding and modulation schemes, there are not sufficient data bits to fill information bit positions in an LDPC code word. Therefore, a shortening (shorten) operation needs to be performed before a parity bit (parity bits) is generated. The shortening (shorten) operation means inserting a specific quantity of 0s into information bit positions in an LDPC code word before a parity bit is generated through LDPC encoding. The 0s are deleted after a parity bit is generated through LDPC encoding. FIG. 5 is a diagram of an LDPC encoding process in a WLAN according to an embodiment of this application. As shown in FIG. 5, the LDPC encoding process in the WLAN includes at least step 1 (step 1) to step 6 (step 6). Specifically, step 1 includes to-be-encoded data bits, for example, payload bits (payload bits). In step 2, a length $L_{LDPC}$ of an LDPC code word and a quantity $N_{CW}$ of code words are determined. For a specific determining manner, refer to the following descriptions. In step 3, a shortening operation is performed on the to-be-encoded data bits. To be specific, shortening zero bits (shortening zero bits) are added after the to-be-encoded data bits. In step 4, to-be-encoded data bits and shortening zero bits in each LDPC code word are encoded by using an LDPC code parity-check matrix to generate parity bits. Then the shortening zero bits are deleted. In step 5, some to-be-encoded data bits in the LDPC code word are repeated (repeat), or the parity bits in the LDPC code word are punctured (puncture). In this way, processed (punctured or repeated) code word bits exactly fill a to-be-transmitted OFDM symbol. To be specific, a quantity of processed code word (punctured or repeated) bits is equal to a quantity of bits that can be carried in the OFDM symbol. In step 6, a plurality of code words are concatenated (concatenation), and stream parsing (stream parsing) is performed.

In this application, an "LDPC code length" is a length of an LDPC code word (LDPC code word length), and the "LDPC code length", the "length of an LDPC code word", and the "LDPC code word length" may be used interchangeably.

2. Method for determining a length of an LDPC code word in the 802.11ac/ax standards

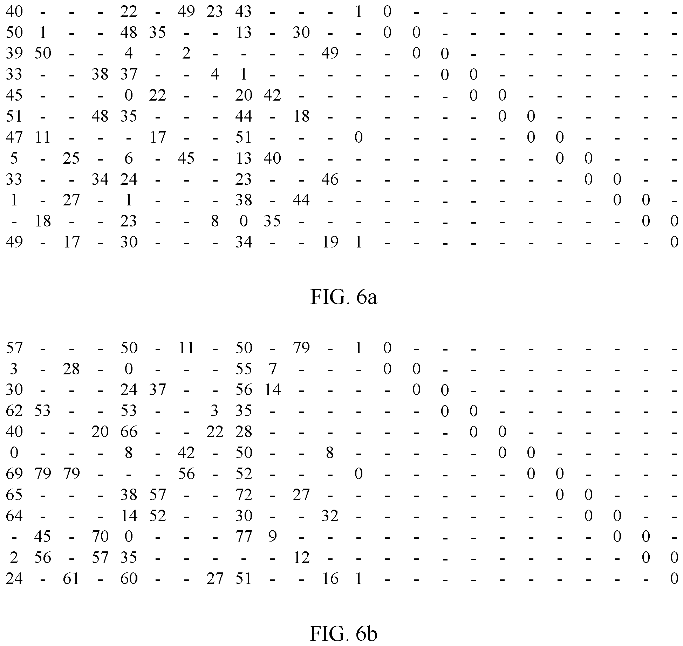

In the 802.11ac/ax standards, a total of 12 LDPC code parity-check matrices are used, and three code lengths are included: 648 bits, 1296 bits, and 1944 bits. Each code length supports four different bit rates (the bit rates herein are reference bit rates): 1/2, 2/3, 3/4, and 5/6. FIG. 6a and FIG. 6b show an LDPC code parity-check matrix with a bit rate of 1/2 (namely, R = 1/2) and a code length of 1296 bits and an LDPC code parity-check matrix with a bit rate of 1/2 and a code length of 1944 bits respectively. An LDPC code parity-check matrix with a bit rate of 1/2 and a code length of 648 bits is shown in FIG. 4a. It should be understood that, for meanings of elements in FIG. 6a and FIG. 6b, reference may be made to the meanings of the elements in FIG. 4a. Details are not described herein again.

Optionally, selection of a bit rate in the 802.11ac/ax standards is determined by a modulation and coding scheme (modulation and coding scheme, MCS) adaptively selected by a link. In a WLAN, an LDPC code is selected from the 12 parity-check matrices based on a code length and a bit rate, and different code lengths and bit rates correspond to different parity-check matrices. For a given bit rate, in an existing WLAN standard, an LDPC code length needed for current data transmission is calculated jointly based on a current data packet length and a current quantity of OFDM symbols.

Specifically, manners of calculating an LDPC code word length in existing WLAN standards are as follows:

1. A quantity of OFDM symbols needed for current data transmission is calculated:

$$N_{SYM} = m_{STBC} \cdot \left\lceil \frac{8 \cdot length + 16}{m_{STBC} \cdot N_{DBPS}} \right\rceil \quad (1\text{-}1)$$

$N_{SYM}$ indicates the quantity of OFDM symbols needed for the current data transmission, length indicates a length (in bytes (Byte)) of a data packet, $m_{STBC}$ indicates a space-time coding scheme for the data packet (a value is 1 when space-time coding is not used), $N_{DBPS}$ indicates a quantity of data bits carried in each OFDM symbol, and $\lceil \rceil$ indicates rounding up. Details are not described below again.

2. A bit length obtained by adding 16 cyclic redundancy check (cyclic redundancy check, CRC) bits to current data transmission is calculated:

$$N_{pld} = 8 \cdot length + 16 \quad (1\text{-}2)$$

3. A quantity of code word bits in current data transmission is calculated:

$$N_{TCB} = N_{CBPS} \times N_{SYM} \quad (1\text{-}3)$$

$N_{TCB}$ indicates the quantity of code word bits in the current data transmission, and $N_{CBPS}$ indicates a quantity of code word bits carried in each OFDM symbol.

4. An LDPC code word length for current data transmission is determined based on the foregoing parameters ($N_{TCB}$, $N_{pld}$, and the like) and the following Table 1.

**Table 1**

| Range of $N_{TCB}$ (range (bits) of $N_{TCB}$) | Quantity of LDPC code words (number of LDPC code words ($N_{CW}$)) | LDPC code word length (LDPC code word length in bits ($L_{LDPC}$)) |
|---|---|---|
| $N_{TCB} \leq 648$ | 1 | 1296, if $N_{TCB} \geq N_{pld} + 912 \times (1 - R)$ 648, otherwise |
| $648 < N_{TCB} \leq 1296$ | 1 | 1944, if $N_{TCB} \geq N_{pld} + 1464 \times (1 - R)$ 1296, otherwise |
| $1296 < N_{TCB} \leq 1944$ | 1 | 1944 |
| $1944 < N_{TCB} \leq 2592$ | 2 | 1944, if $N_{TCB} \geq N_{pld} + 2916 \times (1 - R)$ |
| | | 1296, otherwise |
| $2592 < N_{TCB}$ | $\left\lceil \dfrac{N_{pld}}{1944 \cdot R} \right\rceil$ | 1944 |

It should be understood that R in Table 1 indicates a bit rate.

In a WLAN standard, in addition to the foregoing parameters ($N_{TCB}$, $N_{pld}$, and the like), performance of a long code and a quantity of to-be-punctured bits further need to be comprehensively considered for selecting an LDPC code word length. As shown in step 5 in FIG. 5, in the WLAN, a puncturing operation may need to be performed after LDPC encoding. To be specific, one or more parity bits at the end are not transmitted. However, puncturing causes an increase in an actual bit rate (to be specific, an actual bit rate is greater than a reference bit rate), leading to performance loss to some extent. A longer LDPC code has better error control performance. Therefore, a long code should be selected during code length selection. However, in practice, a code length of an LDPC code in the WLAN needs to be selected based on a tradeoff between a long code and a quantity of to-be-punctured bits. As shown in Table 1, a code length to be selected for an LDPC code in the WLAN does not monotonically increase with an increase in a data packet length, but may continuously decrease to a shorter code length with an increase in a data packet length. In addition, because encoded bits need to fill at least a single OFDM symbol, when a shortest packet length (to be specific, $N_{TCB} \leq 648$) is used, a medium code length (1296 bits), instead of a shortest code length (648 bits), is selected for an LDPC code in the WLAN.

It can be learned from the foregoing content that the LDPC code is widely used in WLAN standards, to improve transmission reliability of a wireless transmission system. In a next-generation UWB standard such as the IEEE 802.15ab standard, an LDPC code with a bit rate of 1/2 in the WLAN is to be introduced to improve transmission reliability of a system. An important candidate solution is to reuse LDPC codes, in the WLAN, whose bit rates are 1/2 and whose code lengths are 648 bits, 1296 bits, and 1944 bits. However, if the LDPC codes, in the WLAN, whose bit rates are 1/2 and whose code lengths are 648 bits, 1296 bits, and 1944 bits are reused, how to determine a length of an LDPC code word in a UWB system urgently needs to be studied.

This application provides a method for determining a length of an LDPC code word in a UWB system and a related apparatus, to ensure that a long code is used as much as possible in UWB transmission to achieve higher error control performance gain, and reduce bit rate loss caused by excessive shortening zero bits.

Technical solutions provided in this application are described below in detail with reference to more accompanying drawings.

To clearly describe the technical solutions of this application, this application is described by using a plurality of embodiments. For details, refer to the following descriptions. In this application, for same or similar parts of embodiments or implementations, mutual reference may be made between the embodiments or implementations, unless otherwise specified. In embodiments of this application and implementations/methods/implementation methods of embodiments, unless otherwise specified or a logical conflict occurs, terms and/or descriptions in different embodiments and implementations/methods/implementation methods of embodiments are consistent and may be mutually referenced. Technical features in different embodiments and implementations/methods/implementation methods of embodiments may be combined to form a new embodiment, implementation, method, or implementation method based on an internal logical relationship between the technical features. The following implementations of this application are not intended to limit the protection scope of this application. It should be understood that a sequence of the following embodiments does not represent a degree of importance.

**Embodiment 1**

Embodiment 1 of this application mainly describes a method for determining a length of an LDPC code word in a UWB system when LDPC codes with three code lengths (648 bits, 1296 bits, and 1944 bits) in a WLAN are reused.

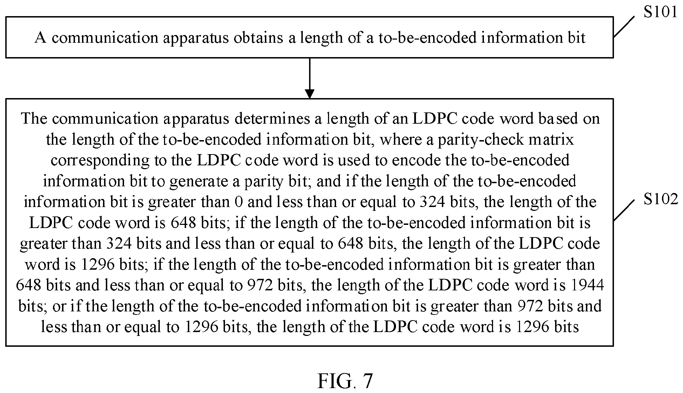

FIG. 7 is a schematic flowchart of a method for determining a length of an LDPC code word in a UWB system according to an embodiment of this application. A communication apparatus in the method may be any device in FIG. 1 or FIG. 2. As shown in FIG. 7, the method for determining a length of an LDPC code word in a UWB system includes but is not limited to the following steps.

S101: A communication apparatus obtains a length of a to-be-encoded information bit.

In this embodiment of this application, the to-be-encoded information bit may be an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in this embodiment of this application.

S102: The communication apparatus determines a length of an LDPC code word based on the length of the to-be-encoded information bit, where a parity-check matrix corresponding to the LDPC code word is used to encode the to-be-encoded information bit to generate a parity bit; and if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; if the length of the to-be-encoded information bit is greater than 648 bits and less than or equal to 972 bits, the length of the LDPC code word is 1944 bits; or if the length of the to-be-encoded information bit is greater than 972 bits and less than or equal to 1296 bits, the length of the LDPC code word is 1296 bits.

A reference bit rate R of the LDPC code word is 1/2.

Optionally, that the communication apparatus determines a length of an LDPC code word based on the length of the to-be-encoded information bit includes: If the length of the to-be-encoded information bit is greater than 0 and less than or equal to 324 bits, the communication apparatus determines that the length of the LDPC code word is 648 bits. If the length of the to-be-encoded information bit is greater than 324 bits and less than or equal to 648 bits, the communication apparatus determines that the length of the LDPC code word is 1296 bits. If the length of the to-be-encoded information bit is greater than 648 bits and less than or equal to 972 bits, the communication apparatus determines that the length of the LDPC code word is 1944 bits. If the length of the to-be-encoded information bit is greater than 972 bits and less than or equal to 1296 bits, the communication apparatus determines that the length of the LDPC code word is 1296 bits. In a possible implementation, if the length of the to-be-encoded information bit is greater than 1296 bits, the communication apparatus determines that the length of the LDPC code word is 1944 bits. In another possible implementation, if the length of the to-be-encoded information bit is greater than 1296 bits and less than or equal to 1620 bits, the communication apparatus determines that the length of the LDPC code word is 648 bits; if the length of the to-be-encoded information bit is greater than 1620 bits and less than or equal to 1944 bits, the communication apparatus determines that the length of the LDPC code word is 1944 bits; if the length of the to-be-encoded information bit is greater than 1944 bits and less than or equal to 2592 bits, the communication apparatus determines that the length of the LDPC code word is 1296 bits; or if the length of the to-be-encoded information bit is greater than 2592 bits, the communication apparatus determines that the length of the LDPC code word is 1944 bits.

In other words, the communication apparatus may determine the length of the LDPC code word based on the length of the to-be-encoded information bit and at least one row in Table 2 or Table 3. The parity-check matrix corresponding to the LDPC code word is used to encode the to-be-encoded information bit to generate the parity bit. Table 2 and Table 3 may be defined in a standard, or may be preset, or may be determined by both communication entities through negotiation, or the like. It can be understood that Table 2 and Table 3 are merely examples. In actual application, a relationship between a length range of the to-be-encoded information bit and the length of the LDPC code word may be a subset in Table 2 or Table 3. In other words, rows shown in Table 2 may be decoupled from each other, and in actual application, some or all of the rows shown in Table 2 may exist. Similarly, rows shown in Table 3 may be decoupled from each other, and in actual application, some or all of the rows shown in Table 3 may exist.

Table 2

| Length range of the to-be-encoded information bit (range (bits) of Inf_Num) | LDPC code word length (LDPC code word length in bits ($L_{LDPC}$)) |
|---|---|
| $0 < \text{Inf\_Num} \leq 324$ | 648 |
| $324 < \text{Inf\_Num} \leq 648$ | 1296 |
| $648 < \text{Inf\_Num} \leq 972$ | 1944 |
| $972 < \text{Inf\_Num} \leq 1296$ | 1296 |
| $1296 < \text{Inf\_Num}$ | 1944 |

**Table 3**

| Length range of the to-be-encoded information bit (range (bits) of Inf_Num) | LDPC code word length (LDPC code word length in bits ($L_{LDPC}$)) |
|---|---|
| $0 < \text{Inf\_Num} \leq 324$ | 648 |
| $324 < \text{Inf\_Num} \leq 648$ | 1296 |
| $648 < \text{Inf\_Num} \leq 972$ | 1944 |
| $972 < \text{Inf\_Num} \leq 1296$ | 1296 |
| $1296 < \text{Inf\_Num} \leq 1620$ | 648 |
| $1620 < \text{Inf\_Num} \leq 1944$ | 1944 |
| $1944 < \text{Inf\_Num} \leq 2592$ | 1296 |
| $2592 < \text{Inf\_Num}$ | 1944 |

"Inf_Num" in Table 2 and Table 3 indicates the length of the to-be-encoded information bit. Same characters in the following descriptions indicate a same meaning, and details are not described again.

Optionally, after step S102, the communication apparatus may generate the LDPC code word based on the determined length of the LDPC code word, the to-be-encoded information bit, the reference bit rate (1/2) of the LDPC code word, and other information, and transmit the LDPC code word. The LDPC code word includes the to-be-encoded information bit and the parity bit generated by encoding the to-be-encoded information bit (or the to-be-encoded information bit and a shortening zero bit) by using the parity-check matrix corresponding to the LDPC code word. For example, for a manner of generating the LDPC code word by the communication apparatus, refer to step 1 to step 4 in FIG. 5. For example, the communication apparatus may transmit the LDPC code word to another communication apparatus, or transmit the LDPC code word to a next module of the channel coding module for processing. For example, for a manner of transmitting the LDPC code word by the communication apparatus, refer to step 6 in FIG. 5. In other words, because the UWB system does not include an OFDM symbol, an LDPC encoding process in the UWB system does not include step 5 in FIG. 5.

In this embodiment of this application, a quantity of shortening zero bits in the LDPC code word may be determined based on the length of the to-be-encoded information bit and a quantity of information bits in the LDPC code word. The quantity of information bits in the LDPC code word is determined based on the length of the LDPC code word and the reference bit rate. Specifically, the quantity of shortening zero bits is as follows:

$$\text{Padding\_Num} = \text{mod}(K - \text{mod}(\text{Inf\_Num}, K), K) \quad (2\text{-}1)$$

Padding_Num indicates the quantity of shortening zero bits in the LDPC code word, K indicates the quantity of information bits in the LDPC code word, Inf_Num indicates the length of the to-be-encoded information bit, and mod indicates a modulo operation. A same expression in the following descriptions indicates a same meaning, and details are not described again. $K = N \times R$, N indicates the length of the LDPC code word, and R indicates the reference bit rate of the LDPC code word.

Beneficial effect of this embodiment of this application is described below in detail with reference to design ideas of Table 2 and Table 3.

It can be understood that an LDPC encoding process in a WLAN system is shown in FIG. 5, and all encoded bits of a code word need to be placed into a to-be-transmitted OFDM symbol. If a quantity of all encoded bits of the code word exceeds a quantity of bits that can be carried in the OFDM symbol, a puncturing operation needs to be performed on the code word, so that bits obtained by puncturing all the encoded bits of the code word can be exactly placed into the to-be-transmitted OFDM symbol. If a quantity of all encoded bits of the code word is less than a quantity of bits that can be carried in the OFDM symbol, a repetition operation needs to be performed on some information bits in the code word to fill the OFDM symbol.

Different from the WLAN system, the UWB system does not include an OFDM symbol. To be specific, during UWB transmission, encoded bits of a code word do not need to be carried in an OFDM symbol, and therefore some parity bits that may exceed a maximum quantity of bits that can be carried in an OFDM symbol do not need to be removed through puncturing. Therefore, during selection of a length of an LDPC code word in the UWB system, performance and bit rate waste (to be specific, excessive shortening zero bits) need to be considered, but repeated bits (repeat bits) or punctured bits caused by an OFDM symbol do not need to be considered, to be specific, impact of step 5 in FIG. 5 on selection of a length of an LDPC code word does not need to be considered. In other words, a manner of selecting (or determining) a length of an LDPC code word in the UWB system is different from a manner of selecting (or determining) a length of an LDPC code word in the WLAN system. However, a tradeoff between a long code and a short code also needs to be considered during selection (determining) of a length of an LDPC code word in the UWB system. A reason is as follows: If a long code (for example, an LDPC code with a length of 1944 bits) is always used, better error control performance is achieved, but a large number of shortening zero bits (shortening zero bits) are needed for a to-be-encoded information bit with a short length, causing a waste of a bit rate. If a short code (for example, an LDPC code with a length of 648 bits) is always used, for a long data packet, compared with a case in which a long code is used, performance of the long data packet is degraded when the short code is used, in other words, performance loss of the long data packet occurs if the short code is always used.

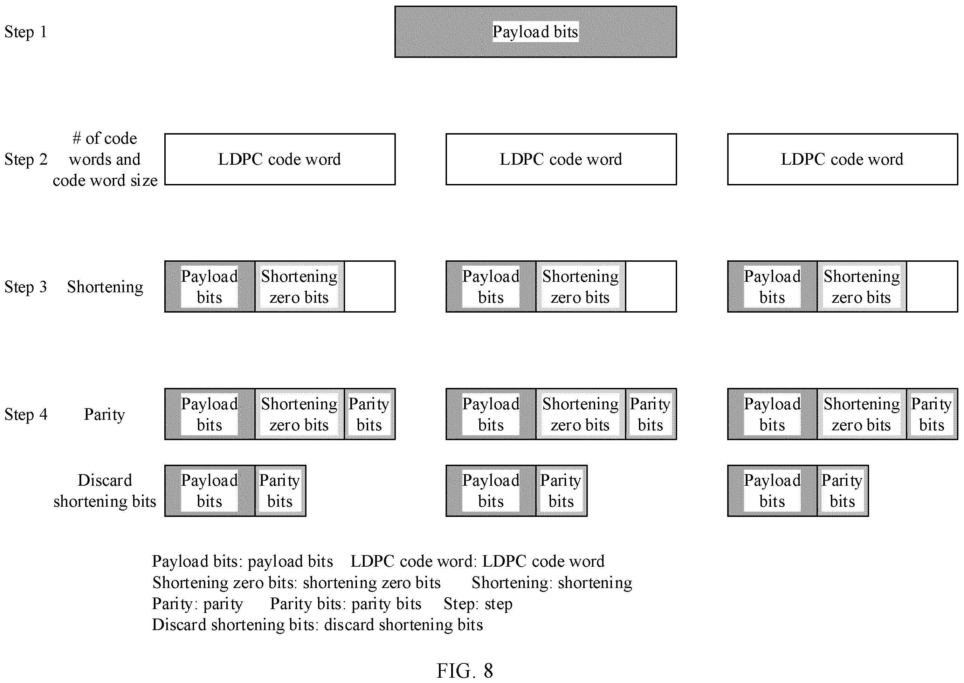

FIG. 8 is a diagram of an LDPC encoding process in a UWB system according to an embodiment of this application. For ease of description, as shown in FIG. 8, an example in which to-be-encoded information bits are payload bits is used. It should be understood that the to-be-encoded information bits in FIG. 8 are not necessarily limited to the payload bits, but may alternatively be a collection of payload bits and CRC bits. In step 3 (step 3), if the to-be-encoded information bits cannot fill information bit positions in an LDPC code word, zeros need to be added after the to-be-encoded information bits to fill the information bit positions in the LDPC code word, and then the to-be-encoded information bits and shortening zero bits (shortening zero bits) are encoded by using a parity-check matrix corresponding to the LDPC code word to generate parity bits. After a complete LDPC code word is obtained through encoding, as shown in step 4, the shortening zero bits added in step 3 are deleted to obtain a final to-be-transmitted code word sequence.

As shown in FIG. 8, the shortening operation in step 3 causes a decrease in an actual bit rate of the final to-be-transmitted code word sequence compared with a reference bit rate of the LDPC code word. For example, for an LDPC code with a reference bit rate of 1/2 (namely, R = 1/2) and a code length of 1944 bits (namely, N = 1944), a quantity of information bits in the LDPC code is as follows: K = N × R = 1944 × (1/2) = 972 bits; and a quantity of parity bits is as follows: M = N × (1 - R) = 1944 × (1/2) = 972 bits. If shortening zero bits are 486 bits, an actual bit rate of the LDPC code is as follows: R' = (972 - 486)/(972 - 486 + 972) = 486/1458 = 1/3. In this case, a bit rate needed for system transmission is 1/2, but the actual bit rate R' of the LDPC code with a length of 1944 bits is 1/3. This causes a waste of a bit rate, and increases overheads of system transmission.

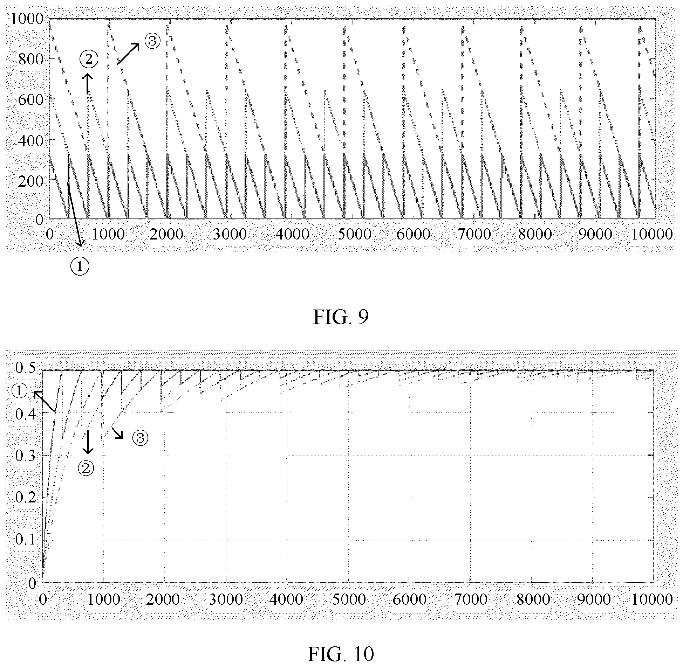

In the manner of calculating a quantity of shortening zero bits in the formula (2-1), when a reference bit rate is fixed at 1/2, a case in which quantities of shortening zero bits needed by LDPC codes with three code lengths (648 bits, 1296 bits, and 1944 bits) vary with a length of a to-be-encoded information bit is shown in FIG. 9. In FIG. 9, a horizontal coordinate indicates a length of a to-be-encoded information bit, and a vertical coordinate indicates a quantity of shortening zero bits. "①" in FIG. 9 indicates a curve of a quantity of shortening zero bits needed by an LDPC code with a reference bit rate of 1/2 and a code length of 648 bits varying with a length of a to-be-encoded information bit. "②" in FIG. 9 indicates a curve of a quantity of shortening zero bits needed by an LDPC code with a reference bit rate of 1/2 and a code length of 1296 bits varying with a length of a to-be-encoded information bit. "③" in FIG. 9 indicates a curve of a quantity of shortening zero bits needed by an LDPC code with a reference bit rate of 1/2 and a code length of 1944 bits varying with a length of a to-be-encoded information bit. To reduce a waste of a bit rate (or transmission overheads), when a length of a to-be-encoded information bit is given, a code length with a smallest quantity of shortening zero bits may be selected. If LDPC codes with a plurality of code lengths need a same quantity of shortening zero bits, an LDPC code with a largest code length is selected, because error control performance of a long code is better. For example, when the length of the to-be-encoded information bit ranges from 0 bits to 324 bits, the LDPC code with a length of 648 bits is selected; when the length of the to-be-encoded information bit ranges from 325 bits to 648 bits, the LDPC code with a length of 1296 bits is selected; when the length of the to-be-encoded information bit ranges from 649 bits to 972 bits, the LDPC code with a length of 1944 bits is selected; when the length of the to-be-encoded information bit ranges from 973 bits to 1296 bits, the LDPC code with a length of 1296 bits is selected; when the length of the to-be-encoded information bit ranges from 1297 bits to 1620 bits, the LDPC code with a length of 648 bits is selected; when the length of the to-be-encoded information bit ranges from 1621 bits to 1944 bits, the LDPC code with a length of 1944 bits is selected; and so on.

However, minimization of the quantity of shortening zero bits causes continuous switching between the three code lengths along with an increase in the length of the to-be-encoded information bit. Consequently, a short code is selected for a long data packet (for example, when the length of the to-be-encoded information bit ranges from 1297 bits to 1620 bits, the LDPC code with a length of 648 bits is selected), causing performance loss. To reduce performance loss of a long data packet, in this embodiment of this application, an effective bit rate may be used to assist in code length selection. The effective bit rate (Rate_E) may be determined based on a length (Inf_Num) of a to-be-encoded information bit, a quantity (K) of information bits in an LDPC code word, and a quantity (M) of parity bits in the LDPC code word. Specifically, the effective bit rate (Rate_E) may be expressed as follows:

$$\text{Rate\_E} = \text{Inf\_Num}/\text{Trans\_Bits} \quad (2\text{-}2)$$

$$\text{Trans\_Bits} = \text{Inf\_Num} + (\text{floor}((\text{Inf\_Num} - 1)/K) + 1) \times M \quad (2\text{-}3)$$

floor indicates rounding down.

In the manner of calculating the effective bit rate (Rate_E) in the formula (2-2), when a reference bit rate is fixed at 1/2, a case in which effective bit rates of LDPC codes with three code lengths (648 bits, 1296 bits, and 1944 bits) vary with a length of a to-be-encoded information bit is shown in FIG. 10. In FIG. 10, a horizontal coordinate indicates a length of a to-be-encoded information bit, and a vertical coordinate indicates an effective bit rate. "①" in FIG. 10 indicates a curve of an effective bit rate of an LDPC code with a reference bit rate of 1/2 and a code length of 648 bits varying with a length of a to-be-encoded information bit. "②" in FIG. 10 indicates a curve of an effective bit rate of an LDPC code with a reference bit rate of 1/2 and a code length of 1296 bits varying with a length of a to-be-encoded information bit. "③" in FIG. 10 indicates a curve of an effective bit rate of an LDPC code with a reference bit rate of 1/2 and a code length of 1944 bits varying with a length of a to-be-encoded information bit. To reduce performance loss of a long data packet, when a length of a to-be-encoded information bit is given, a code length with a higher effective bit rate may be selected. If LDPC codes with a plurality of code lengths have a same effective bit rate, an LDPC code with a largest code length is selected, because error control performance of a long code is better. For example, when the length of the to-be-encoded information bit ranges from 0 bits to 324 bits, the LDPC code with a length of 648 bits is selected; when the length of the to-be-encoded information bit ranges from 325 bits to 648 bits, the LDPC code with a length of 1296 bits is selected; when the length of the to-be-encoded information bit ranges from 649 bits to 972 bits, the LDPC code with a length of 1944 bits is selected; when the length of the to-be-encoded information bit ranges from 973 bits to 1296 bits, the LDPC code length with a length of 1296 bits is selected; and so on.

It can be understood that, as shown in FIG. 10, the effective bit rate (Rate_E) is increasingly close to the reference bit rate 1/2 with a continuous increase in the length of the to-be-encoded information bit. Therefore, when to-be-encoded information bits are quite long, bit rate loss caused by shortening zero bits is quite small. To be specific, when to-be-encoded information bits are quite long, an LDPC code with a largest code length (namely, 1944 bits) may be selected. This is because a long code has higher error control performance gain.

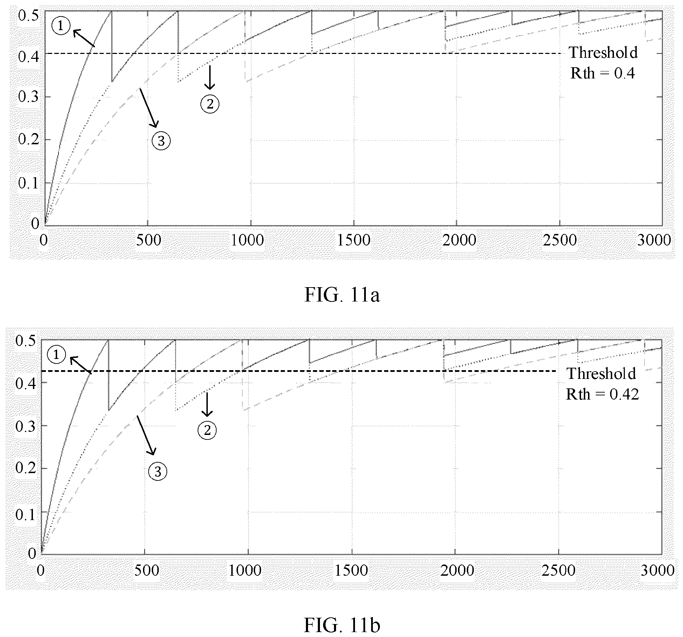

In this embodiment of this application, a length of an LDPC code word is selected based on the effective bit rate. Specifically, a threshold Rth is set. When the effective bit rate is greater than the threshold Rth, a longest code word is selected to achieve optimal coding gain. When the effective bit rate is less than or equal to the threshold Rth, a code word length with a highest effective bit rate is selected. For example, FIG. 11a is a diagram of selecting a length of an LDPC code word according to an embodiment of this application. As shown in FIG. 11a, assuming that the threshold Rth is 0.4, Table 2 may be obtained according to the foregoing principle. For another example, FIG. 11b is another diagram of selecting a length of an LDPC code word according to an embodiment of this application. As shown in FIG. 11b, assuming that the threshold Rth is 0.42, Table 3 may be obtained according to the foregoing principle. In FIG. 11a and FIG. 11b, a horizontal coordinate indicates a length of a to-be-encoded information bit, and a vertical coordinate indicates an effective bit rate. In FIG. 11a and FIG. 11b, "①" indicates a curve of an effective bit rate of an LDPC code with a reference bit rate of 1/2 and a code length of 648 bits varying with a length of a to-be-encoded information bit, "②" indicates a curve of an effective bit rate of an LDPC code with a reference bit rate of 1/2 and a code length of 1296 bits varying with a length of a to-be-encoded information bit, and "③" indicates a curve of an effective bit rate of an LDPC code with a reference bit rate of 1/2 and a code length of 1944 bits varying with a length of a to-be-encoded information bit.

Therefore, in the method for determining a length of an LDPC code word in this embodiment of this application, a tradeoff is made between the effective bit rate and performance of a long code, to ensure that a long code is used as much as possible in UWB transmission to achieve higher error control performance gain, and avoid bit rate loss caused by excessive shortening zero bits when a length of a to-be-encoded information bit is small.

In some scenarios, to reduce power consumption in the UWB system, only LDPC codes with short and medium code lengths, to be specific, LDPC codes with code lengths of 648 bits and 1296 bits, in the WLAN may be reused.

**Embodiment 2**

Embodiment 2 of this application mainly describes a manner of determining a length of an LDPC code word in a UWB system when LDPC codes with short and medium code lengths (648 bits and 1296 bits) in a WLAN are reused.

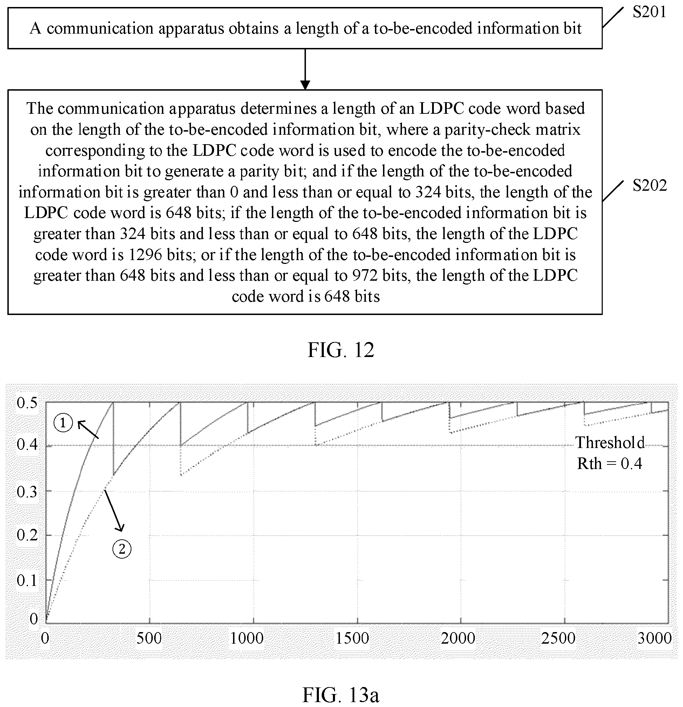

FIG. 12 is another schematic flowchart of a method for determining a length of an LDPC code word in a UWB system according to an embodiment of this application. A communication apparatus in the method may be any device in FIG. 1 or FIG. 2. As shown in FIG. 12, the method for determining a length of an LDPC code word in a UWB system includes but is not limited to the following steps.

S201: A communication apparatus obtains a length of a to-be-encoded information bit.

In this embodiment of this application, the to-be-encoded information bit may be an information bit that has not undergone channel coding, in other words, an information bit input to an input end of a channel coding module. For example, the to-be-encoded information bit may be a to-be-encoded data bit (namely, a payload bit), or the to-be-encoded information bit may include a to-be-encoded data bit and a CRC bit. This is not limited in this embodiment of this application.

S202: The communication apparatus determines a length of an LDPC code word based on the length of the to-be-encoded information bit, where a parity-check matrix corresponding to the LDPC code word is used to encode the to-be-encoded information bit to generate a parity bit; and if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; or if the length of the to-be-encoded information bit is greater than 648 bits and less than or equal to 972 bits, the length of the LDPC code word is 648 bits.

A reference bit rate R of the LDPC code word is 1/2.

Optionally, that the communication apparatus determines a length of an LDPC code word based on the length of the to-be-encoded information bit includes: If the length of the to-be-encoded information bit is greater than 0 and less than or equal to 324 bits, the communication apparatus determines that the length of the LDPC code word is 648 bits. If the length of the to-be-encoded information bit is greater than 324 bits and less than or equal to 648 bits, the communication apparatus determines that the length of the LDPC code word is 1296 bits. If the length of the to-be-encoded information bit is greater than 648 bits and less than or equal to 972 bits, the communication apparatus determines that the length of the LDPC code word is 648 bits. In a possible implementation, if the length of the to-be-encoded information bit is greater than 972 bits, the communication apparatus determines that the length of the LDPC code word is 1296 bits. In another possible implementation, if the length of the to-be-encoded information bit is greater than 972 bits and less than or equal to 1296 bits, the communication apparatus determines that the length of the LDPC code word is 1296 bits; if the length of the to-be-encoded information bit is greater than 1296 bits and less than or equal to 1620 bits, the communication apparatus determines that the length of the LDPC code word is 648 bits; or if the length of the to-be-encoded information bit is greater than 1620 bits, the communication apparatus determines that the length of the LDPC code word is 1296 bits.

In other words, the communication apparatus may determine the length of the LDPC code word based on the length of the to-be-encoded information bit and at least one row in Table 4 or Table 5. The parity-check matrix corresponding to the LDPC code word is used to encode the to-be-encoded information bit to generate the parity bit. Table 4 and Table 5 may be defined in a standard, or may be preset, or may be determined by both communication entities through negotiation, or the like. It can be understood that Table 4 and Table 5 are merely examples. In actual application, a relationship between a length range of the to-be-encoded information bit and the length of the LDPC code word may be a subset in Table 4 or Table 5. In other words, rows shown in Table 4 may be decoupled from each other, and in actual application, some or all of the rows shown in Table 4 may exist. Similarly, rows shown in Table 5 may be decoupled from each other, and in actual application, some or all of the rows shown in Table 5 may exist.

**Table 4**

| Length range of the to-be-encoded information bit (range (bits) of Inf_Num) | LDPC code word length (LDPC code word length in bits ($L_{LDPC}$)) |
| --- | --- |
| $0 < Inf\_Num \leq 324$ | 648 |
| $324 < Inf\_Num \leq 648$ | 1296 |
| $648 < Inf\_Num \leq 972$ | 648 |
| $972 < Inf\_Num$ | 1296 |

**Table 5**

| Length range of the to-be-encoded information bit (range (bits) of Inf_Num) | LDPC code word length (LDPC code word length in bits ($L_{LDPC}$)) |
| --- | --- |
| $0 < Inf\_Num \leq 324$ | 648 |
| $324 < Inf\_Num \leq 648$ | 1296 |
| $648 < Inf\_Num \leq 972$ | 648 |
| $972 < Inf\_Num \leq 1296$ | 1296 |
| $1296 < Inf\_Num \leq 1620$ | 648 |
| $1620 < Inf\_Num$ | 1296 |

"Inf_Num" in Table 4 and Table 5 indicates the length of the to-be-encoded information bit.

Optionally, after step S202, the communication apparatus may generate the LDPC code word based on the determined length of the LDPC code word, the to-be-encoded information bit, the reference bit rate (1/2) of the LDPC code word, and other information, and transmit the LDPC code word. The LDPC code word includes the to-be-encoded information bit and the parity bit generated by encoding the to-be-encoded information bit (or the to-be-encoded information bit and a shortening zero bit) by using the parity-check matrix corresponding to the LDPC code word. For example, for a manner of generating the LDPC code word by the communication apparatus, refer to step 1 to step 4 in FIG. 5. For example, the communication apparatus may transmit the LDPC code word to another communication apparatus, or transmit the LDPC code word to a next module of the channel coding module for processing. For example, for a manner of transmitting the LDPC code word by the communication apparatus, refer to step 6 in FIG. 5. In other words, because the UWB system does not include an OFDM symbol, an LDPC encoding process in the UWB system does not include step 5 in FIG. 5.

In this embodiment of this application, a quantity of shortening zero bits in the LDPC code word may be determined based on the length of the to-be-encoded information bit and a quantity of information bits in the LDPC code word. The quantity of information bits in the LDPC code word is determined based on the length of the LDPC code word and the reference bit rate. Specifically, the quantity of shortening zero bits is determined based on the formula (2-1).

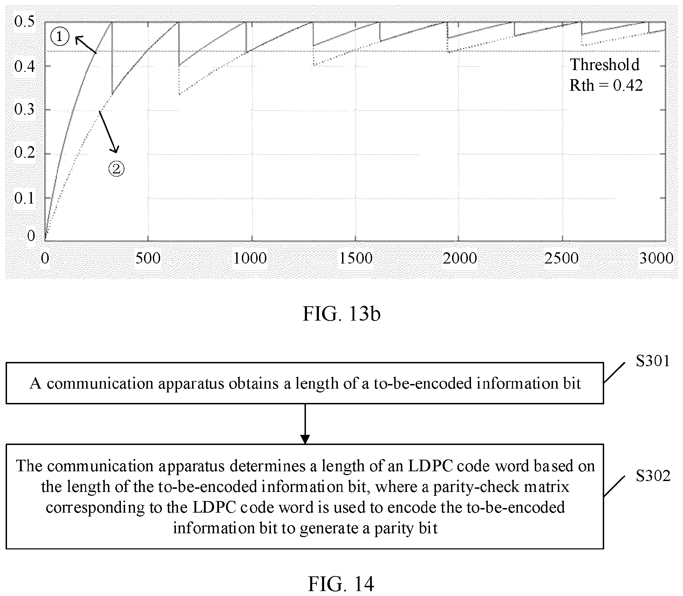

It can be understood that design ideas of Table 4 and Table 5 in this embodiment of this application are similar to the design ideas of Table 2 and Table 3 in Embodiment 1. Specifically, in this embodiment of this application, to reduce power consumption in the UWB system, only LDPC codes with short and medium code lengths, to be specific, LDPC codes with code lengths of 648 bits and 1296 bits, in the WLAN are reused. In addition, a length of an LDPC code word is selected based on the effective bit rate. Specifically, a threshold Rth is set. When the effective bit rate is greater than the threshold Rth, a longer one of a 648-bit code word and a 1296-bit code word is selected to achieve optimal coding gain. When the

EP 4 539 370 A1

effective bit rate is less than or equal to the threshold Rth, a code word length with a highest effective bit rate is selected. For example, FIG. 13a is still another diagram of selecting a length of an LDPC code word according to an embodiment of this application. As shown in FIG. 13a, assuming that the threshold Rth is 0.4, Table 4 may be obtained according to the foregoing principle. For another example, FIG. 13b is yet another diagram of selecting a length of an LDPC code word according to an embodiment of this application. As shown in FIG. 13b, assuming that the threshold Rth is 0.42, Table 5 may be obtained according to the foregoing principle. In FIG. 13a and FIG. 13b, a horizontal coordinate indicates a length of a to-be-encoded information bit, and a vertical coordinate indicates an effective bit rate. In FIG. 13a and FIG. 13b, "①" indicates a curve of an effective bit rate of an LDPC code with a reference bit rate of 1/2 and a code length of 648 bits varying with a length of a to-be-encoded information bit, "②" indicates a curve of an effective bit rate of an LDPC code with a reference bit rate of 1/2 and a code length of 1296 bits varying with a length of a to-be-encoded information bit.

For beneficial effect of this embodiment of this application, refer to the beneficial effect of Embodiment 1. Specifically, in this embodiment of this application, a tradeoff is still made between the effective bit rate and performance of a long code, to ensure that a long code is used as much as possible in UWB transmission to achieve higher error control performance gain, and avoid bit rate loss caused by excessive shortening zero bits when a length of a to-be-encoded information bit is small. In addition, in this embodiment of this application, only LDPC codes with short and medium code lengths (to be specific, LDPC codes with code lengths of 648 bits and 1296 bits) in the WLAN are used, to reduce power consumption in the UWB system.

It can be understood that the length of the to-be-encoded information bit in Embodiment 1 and Embodiment 2 is designed and described in bits (bit). In some scenarios, the length of the to-be-encoded information bit may alternatively be expressed in bytes (byte). In this case, a method for determining a length of an LDPC code word in a UWB system may be described in Embodiment 3. It can be further understood that a design idea of Embodiment 3 is similar to the design ideas of Embodiment 1 and Embodiment 2. For beneficial effect of Embodiment 3, refer to the beneficial effect of Embodiment 1 and Embodiment 2.

**Embodiment 3**

FIG. 14 is still another schematic flowchart of a method for determining a length of an LDPC code word in a UWB system according to an embodiment of this application. A communication apparatus in the method may be any device in FIG. 1 or FIG. 2. As shown in FIG. 14, the method for determining a length of an LDPC code word in a UWB system includes but is not limited to the following steps.

S301: A communication apparatus obtains a length of a to-be-encoded information bit.

In this embodiment of this application, the to-be-encoded information bit may be an information bit that has not undergone channel coding, in other words, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in this embodiment of this application.

S302: The communication apparatus determines a length of an LDPC code word based on the length of the to-be-encoded information bit, where a parity-check matrix corresponding to the LDPC code word is used to encode the to-be-encoded information bit to generate a parity bit.

Optionally, the communication apparatus may determine the length of the LDPC code word based on the length of the to-be-encoded information bit in any one of the following implementations 1 to 4.

Implementation 1:

The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than or equal to 41 bytes and less than or equal to 81 bytes, the length of the LDPC code word is 1296 bits. If the length of the to-be-encoded information bit is greater than or equal to 82 bytes and less than or equal to 121 bytes, the length of the LDPC code word is 1944 bits. If the length of the to-be-encoded information bit is greater than or equal to 122 bytes and less than or equal to 162 bytes, the length of the LDPC code word is 1296 bits. In a possible implementation, if the length of the to-be-encoded information bit is greater than or equal to 163 bytes, the length of the LDPC code word is 1944 bits. In another possible implementation, the length of the to-be-encoded information bit and the length of the LDPC code word meet one or more of the following conditions: If the length of the to-be-encoded information bit is greater than or equal to 163 bytes and less than or equal to 202 bytes, the length of the LDPC code word is 648 bits. If the length of the to-be-encoded information bit is greater than or equal to 203 bytes and less than or equal to 243 bytes, the length of the LDPC code word is 1944 bits. If the length of the to-be-encoded information bit is greater than or equal to 244 bytes and less than or equal to 324 bytes, the length of the LDPC code word is 1296 bits. If the length of the to-be-encoded information bit is greater than or equal to 325 bytes, the length of the LDPC code word is 1944 bits.

19

For example, a relationship between a length range of the to-be-encoded information bit and the length of the LDPC code word in the implementation 1 may be shown in at least one row in Table 6 or Table 7. For example, when the length of the to-be-encoded information bit is greater than 0 and less than or equal to 40 bytes, the length of the LDPC code word is 648 bits. For another example, when the length of the to-be-encoded information bit is greater than or equal to 41 bytes and less than or equal to 81 bytes, the length of the LDPC code word is 1296 bits. For still another example, when the length of the to-be-encoded information bit is greater than or equal to 82 bytes and less than or equal to 121 bytes, the length of the LDPC code word is 1944 bits. For still another example, when the length of the to-be-encoded information bit is greater than or equal to 122 bytes and less than or equal to 162 bytes, the length of the LDPC code word is 1296 bits. For yet another example, when the length of the to-be-encoded information bit is greater than or equal to 163 bytes, the length of the LDPC code word is 1944 bits. It can be understood that same or similar descriptions below represent same or similar meanings, and details are not described again.

Table 6 and Table 7 may be defined in a standard, or may be preset, or may be determined by both communication entities through negotiation, or the like. It can be understood that Table 6 and Table 7 are merely examples. In actual application, a relationship between a length range of the to-be-encoded information bit and the length of the LDPC code word may be a subset in Table 6 or Table 7. In other words, rows shown in Table 6 may be decoupled from each other, and in actual application, some or all of the rows shown in Table 6 may exist. Similarly, rows shown in Table 7 may be decoupled from each other, and in actual application, some or all of the rows shown in Table 7 may exist.

**Table 6**

| Length range of the to-be-encoded information bit (range (bytes) of Inf_Num) | LDPC code word length (LDPC code word length in bits ($L_{LDPC}$)) |
| --- | --- |
| $0 < Inf\_Num \leq 40$ | 648 |
| $41 \leq Inf\_Num \leq 81$ | 1296 |
| $82 \leq Inf\_Num \leq 121$ | 1944 |
| $122 \leq Inf\_Num \leq 162$ | 1296 |
| $163 \leq Inf\_Num$ | 1944 |

**Table 7**

| Length range of the to-be-encoded information bit (range (bytes) of Inf_Num) | LDPC code word length (LDPC code word length in bits ($L_{LDPC}$)) |
| --- | --- |
| $0 < Inf\_Num \leq 40$ | 648 |
| $41 \leq Inf\ Num \leq 81$ | 1296 |
| $82 \leq Inf\_Num \leq 121$ | 1944 |
| $122 \leq Inf\_Num \leq 162$ | 1296 |
| $163 \leq Inf\_Num \leq 202$ | 648 |
| $203 \leq Inf\_Num \leq 243$ | 1944 |
| $244 \leq Inf\_Num \leq 324$ | 1296 |
| $325 \leq Inf\_Num$ | 1944 |

Implementation 2:

The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than 40 bytes and less than or equal to 81 bytes, the length of the LDPC code word is 1296 bits. If the length of the to-be-encoded information bit is greater than 81 bytes and less than or equal to 121 bytes, the length of the LDPC code word is 1944 bits. If the length of the to-be-encoded information bit is greater than 121 bytes and less than or equal to 162 bytes, the length of the LDPC code word is 1296 bits. In a possible implementation, if the length of the to-be-encoded information bit is greater than 162 bytes, the length of the LDPC code word is 1944 bits. In another possible implementation, the length of the to-be-encoded information bit and the length of the LDPC code word meet one or more of the following conditions: If the length of the to-be-encoded information bit is greater than 162 bytes and less than or equal to 202 bytes, the length of the LDPC code word is 648 bits. If the length of the to-be-encoded information bit is greater than 202 bytes and less than or equal to 243 bytes, the length of the LDPC code word is 1944 bits. If the length of the to-be-encoded information bit is greater than 243 bytes and less than or equal to 324 bytes, the length of the LDPC code word is 1296 bits. If the length of the to-be-encoded information bit is greater than 324 bytes, the length of the LDPC code word is 1944 bits.

For example, a relationship between a length range of the to-be-encoded information bit and the length of the LDPC code word in the implementation 2 may be shown in at least one row in Table 8 or Table 9. Table 8 and Table 9 may be defined in a standard, or may be preset, or may be determined by both communication entities through negotiation, or the like. It can be understood that Table 8 and Table 9 are merely examples. In actual application, a relationship between a length range of the to-be-encoded information bit and the length of the LDPC code word may be a subset in Table 8 or Table 9. In other words, rows shown in Table 8 may be decoupled from each other, and in actual application, some or all of the rows shown in Table 8 may exist. Similarly, rows shown in Table 9 may be decoupled from each other, and in actual application, some or all of the rows shown in Table 9 may exist.

**Table 8**

| Length range of the to-be-encoded information bit (range (bytes) of Inf_Num) | LDPC code word length (LDPC code word length in bits ($L_{LDPC}$)) |
|---|---|
| $0 < \text{Inf\_Num} \leq 40$ | 648 |
| $40 < \text{Inf\_Num} \leq 81$ | 1296 |
| $81 < \text{Inf\_Num} \leq 121$ | 1944 |
| $121 < \text{Inf\_Num} \leq 162$ | 1296 |
| $162 < \text{Inf\_Num}$ | 1944 |

**Table 9**

| Length range of the to-be-encoded information bit (range (bytes) of Inf_Num) | LDPC code word length (LDPC code word length in bits ($L_{LDPC}$)) |
|---|---|
| $0 < \text{Inf\_Num} \leq 40$ | 648 |
| $40 < \text{Inf\_Num} \leq 81$ | 1296 |
| $81 < \text{Inf\_Num} \leq 121$ | 1944 |
| $121 < \text{Inf\_Num} \leq 162$ | 1296 |
| $162 < \text{Inf\_Num} \leq 202$ | 648 |
| $202 < \text{Inf\_Num} \leq 243$ | 1944 |
| $243 < \text{Inf\_Num} \leq 324$ | 1296 |
| $324 < \text{Inf\_Num}$ | 1944 |

Implementation 3:

The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than or equal to 41 bytes and less than or equal to 81 bytes, the length of the LDPC code word is 1296 bits. If the length of the to-be-encoded information bit is greater than or equal to 82 bytes and less than or equal to 121 bytes, the length of the LDPC code word is 648 bits. In a possible implementation, if the length of the to-be-encoded information bit is greater than or equal to 122 bytes, the length of the LDPC code word is 1296 bits. In another possible implementation, the length of the to-be-encoded information bit and the length of the LDPC code word meet one or more of the following conditions: If the length of the to-be-encoded information bit is greater than or equal to 122 bytes and less than or equal to 162 bytes, the length of the LDPC code word is 1296 bits. If the length of the to-be-encoded information bit is greater than or equal to 163 bytes and less than or equal to 202 bytes, the length of the LDPC code word is 648 bits. If the length of the to-be-encoded information bit is greater than or equal to 203 bytes, the length of the LDPC code word is 1296 bits.

For example, a relationship between a length range of the to-be-encoded information bit and the length of the LDPC code word in the implementation 3 may be shown in at least one row (other than the 1st row) in Table 10 or Table 11. Table 10 and Table 11 may be defined in a standard, or may be preset, or may be determined by both communication entities through negotiation, or the like. It can be understood that Table 10 and Table 11 are merely examples. In actual application, a relationship between a length range of the to-be-encoded information bit and the length of the LDPC code word may be a subset in Table 10 or Table 11. In other words, rows shown in Table 10 may be decoupled from each other, and in actual application, some or all of the rows shown in Table 10 may exist. Similarly, rows shown in Table 11 may be decoupled from each other, and in actual application, some or all of the rows shown in Table 11 may exist.

**Table 10**

| Length range of the to-be-encoded information bit (range (bytes) of Inf_Num) | LDPC code word length (LDPC code word length in bits ($L_{LDPC}$)) |
|---|---|
| $0 < Inf\_Num \leq 40$ | 648 |
| $41 \leq Inf\_Num \leq 81$ | 1296 |
| $82 \leq Inf\_Num \leq 121$ | 648 |
| $122 \leq Inf\_Num$ | 1296 |

**Table 11**

| Length range of the to-be-encoded information bit (range (bytes) of Inf_Num) | LDPC code word length (LDPC code word length in bits ($L_{LDPC}$)) |
|---|---|
| $0 < Inf\_Num \leq 40$ | 648 |
| $41 \leq Inf\_Num \leq 81$ | 1296 |
| $82 \leq Inf\_Num \leq 121$ | 648 |
| $122 \leq Inf\_Num \leq 162$ | 1296 |
| $163 \leq Inf\_Num \leq 202$ | 648 |
| $203 \leq Inf\_Num$ | 1296 |

Implementation 4:

The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than 40 bytes and less than or equal to 81 bytes, the length of the LDPC code word is 1296 bits. If the length of the to-be-encoded information bit is greater than 81 bytes and less than or equal to 121 bytes, the length of the LDPC code word is 648 bits. In a possible implementation, if the length of the to-be-encoded information bit is greater than 121 bytes, the length of the LDPC code word is 1296 bits. In another possible implementation, the length of the to-be-encoded information bit and the length of the LDPC code word meet one or more of the following conditions: If the length of the to-be-encoded information bit is greater than 121 bytes and less than or equal to 162 bytes, the length of the LDPC code word is 1296 bits. If the length of the to-be-encoded information bit is greater than 162 bytes and less than or equal to 202 bytes, the length of the LDPC code word is 648 bits. If the length of the to-be-encoded information bit is greater than 202 bytes, the length of the LDPC code word is 1296 bits.

For example, a relationship between a length range of the to-be-encoded information bit and the length of the LDPC code word in the implementation 4 may be shown in at least one row (other than the 1st row) in Table 12 or Table 13. Table 12 and Table 13 may be defined in a standard, or may be preset, or may be determined by both communication entities through negotiation, or the like. It can be understood that Table 12 and Table 13 are merely examples. In actual application, a relationship between a length range of the to-be-encoded information bit and the length of the LDPC code word may be a subset in Table 12 or Table 13. In other words, rows shown in Table 12 may be decoupled from each other, and in actual application, some or all of the rows shown in Table 12 may exist. Similarly, rows shown in Table 13 may be decoupled from each other, and in actual application, some or all of the rows shown in Table 13 may exist.

**Table 12**

| Length range of the to-be-encoded information bit (range (bytes) of Inf_Num) | LDPC code word length (LDPC code word length in bits ($L_{LDPC}$)) |
|---|---|
| $0 < Inf\_Num \leq 40$ | 648 |

(continued)

| Length range of the to-be-encoded information bit (range (bytes) of Inf_Num) | LDPC code word length (LDPC code word length in bits ($L_{LDPC}$)) |
|---|---|
| $40 < Inf\_Num \leq 81$ | 1296 |
| $81 < Inf\_Num \leq 121$ | 648 |
| $121 < Inf\_Num$ | 1296 |

**Table 13**

| Length range of the to-be-encoded information bit (range (bytes) of Inf_Num) | LDPC code word length (LDPC code word length in bits ($L_{LDPC}$)) |
|---|---|
| $0 < Inf\_Num \leq 40$ | 648 |
| $40 < Inf\_Num \leq 81$ | 1296 |
| $81 < Inf\_Num \leq 121$ | 648 |
| $121 < Inf\_Num \leq 162$ | 1296 |
| $162 < Inf\_Num \leq 202$ | 648 |
| $202 < Inf\_Num$ | 1296 |

Implementation 5:

The communication apparatus may determine the length of the LDPC code word based on not only the length of the to-be-encoded information bit, but also a data rate (data rate).

The length of the to-be-encoded information bit and the length of the LDPC code word meet the following conditions: When the length of the to-be-encoded information bit is greater than 121 bytes and less than or equal to 162 bytes, if the data rate (data rate) is less than or equal to a preset threshold, the length of the LDPC code word is 1296 bits. When the length of the to-be-encoded information bit is greater than 121 bytes and less than or equal to 162 bytes, if the data rate is greater than the preset threshold, the length of the LDPC code word is 1944 bits. It can be understood that, if the data rate is equal to the preset threshold, the length of the LDPC code word may be 1296 bits or 1944 bits. In other words, if the data rate is equal to the preset threshold, 1296 bits or 1944 bits may be selected as the length of the LDPC code word based on an actual case. This is not limited in this embodiment of this application.

It can be understood that the data rate (data rate) may also be understood as a data symbol rate (data symbol rate) or a nominal bit rate (nominal bit rate). This is not limited in this embodiment of this application. The data rate may include 1.95 Mbps, 7.8 Mbps, 31.2 Mbps, and 62.4 Mbps, and optionally, further includes 124.8 Mbps. Certainly, with evolution of a standard, the data rate may alternatively include other values, which are not listed one by one herein.

For example, the preset threshold may be 1.95 Mbps, 7.8 Mbps, 31.2 Mbps, or 62.4 Mbps. Alternatively, the preset threshold may be a value obtained by rounding (rounding up or rounding down) 1.95 Mbps, a value obtained by rounding (rounding up or rounding down) 7.8 Mbps, a value obtained by rounding (rounding up or rounding down) 31.2 Mbps, or a value obtained by rounding (rounding up or rounding down) 62.4 Mbps. Alternatively, the preset threshold may be a value around 1.95 Mbps, for example, 1.94 Mbps or 1.96 Mbps; or may be a value around 7.8 Mbps, for example, 7.7 Mbps, 7.6 Mbps, 7.9 Mbps, or 8.0 Mbps; or may be a value around 31.2 Mbps, for example, 31.1 Mbps, 31.15 Mbps, or 31.3 Mbps; or may be a value around 62.4 Mbps, for example, 62.5 Mbps, 62.35 Mbps, 62.34 Mbps, or 62.5 Mbps. Certainly, the preset threshold may alternatively be a range, for example, 1.90 Mbps to 2.0 Mbps, 7.5 Mbps to 8.0 Mbps, 31.0 Mbps to 32.0 Mbps, or 62.3 Mbps to 62.5 Mbps. The preset threshold may be set based on an actual case. A specific value of the preset threshold is not limited in this embodiment of this application.

It can be understood that, in the implementation 5, the length of the LDPC code word is determined based on the data rate, so that transmission performance can be effectively improved, and a delay can be reduced. For example, Table 14 shows a time difference between transmission of an LDPC code word with a length of 1944 bits and transmission of an LDPC code word with a length of 1296 bits in the air when a same data rate is used and a length of a to-be-encoded information bit is greater than 121 bytes and less than or equal to 162 bytes. As shown in Table 14, when the length of the to-be-encoded information bit is greater than 121 bytes and less than or equal to 162 bytes, if the data rate (data rate) is less than or equal to 1.95 Mbps or the data rate is less than 7.8 Mbps, approximately 166 μs (microseconds) can be saved when the LDPC code word with a length of 1944 bits is used, compared with a case in which the LDPC code word with a length of 1296 bits is used.

**Table 14**

| Data rate (data rate) | Air Time of Data Portion (air time of data portion) | Air Time Saving (air time saving) |
|---|---|---|
| 1.95 Mbps | 1944 LDPC: 0.513 × 2920 / 2 = 748.7 μs | 166.2 μs |
| | 1296 LDPC: 0.513 × 2272 / 2 = 582.5 μs | |
| 7.8 Mbps | 1944 LDPC: 0.128 × 2920 / 2 = 186.9 μs | 41.5 μs |
| | 1296 LDPC: 0.128 × 2272 / 2 = 145.4 μs | |
| 31.2 Mbps | 1944 LDPC: 0.032 × 2920 / 2 = 46.8 μs | 10.5 μs |
| | 1296 LDPC: 0.032 × 2272 / 2 = 36.3 μs | |
| 62.4 Mbps | 1944 LDPC: 0.016 × 2920 / 2 = 23.4 μs | 5.3 μs |
| | 1296 LDPC: 0.016 × 2272 / 2 = 18.1 μs | |
| 124.8 Mbps | 1944 LDPC: 0.008 × 2920 / 2 = 11.7 μs | 2.6 μs |
| | 1296 LDPC: 0.008 × 2272 / 2 = 9.1 μs | |

Optionally, the length of the to-be-encoded information bit and the length of the LDPC code word may alternatively meet one or more of the following conditions: If the length of the to-be-encoded information bit is greater than 0 and less than or equal to 21 bytes, the length of the LDPC code word is 648 bits. If the length of the to-be-encoded information bit is greater than 21 bytes and less than or equal to 44 bytes, the length of the LDPC code word is 1296 bits. If the length of the to-be-encoded information bit is greater than 44 bytes and less than or equal to 121 bytes, the length of the LDPC code word is 1944 bits.

In a possible implementation, if the length of the to-be-encoded information bit is greater than 162 bytes, the length of the LDPC code word is 1944 bits. In another possible implementation, the length of the to-be-encoded information bit and the length of the LDPC code word meet one or more of the following conditions: If the length of the to-be-encoded information bit is greater than 162 bytes and less than or equal to 202 bytes, the length of the LDPC code word is 648 bits. If the length of the to-be-encoded information bit is greater than 202 bytes and less than or equal to 243 bytes, the length of the LDPC code word is 1944 bits. If the length of the to-be-encoded information bit is greater than 243 bytes and less than or equal to 324 bytes, the length of the LDPC code word is 1296 bits. If the length of the to-be-encoded information bit is greater than 324 bytes, the length of the LDPC code word is 1944 bits.

For example, a relationship between a length range of the to-be-encoded information bit and the length of the LDPC code word in the implementation 5 may be shown in at least one row in Table 15 or Table 16. In Table 15 and Table 16, R indicates the data rate (data rate), and Rth indicates the preset threshold. Table 15 and Table 16 may be defined in a standard, or may be preset, or may be determined by both communication entities through negotiation, or the like. It can be understood that Table 15 and Table 16 are merely examples. In actual application, a relationship between a length range of the to-be-encoded information bit and the length of the LDPC code word may be a subset in Table 15 or Table 16. In other words, rows shown in Table 15 may be decoupled from each other, and in actual application, some or all of the rows shown in Table 15 may exist. Similarly, rows shown in Table 16 may be decoupled from each other, and in actual application, some or all of the rows shown in Table 16 may exist.

**Table 15**

| Length range of the to-be-encoded information bit (range (bytes) of Inf_Num) | LDPC code word length (LDPC code word length in bits ($L_{LDPC}$)) |
|---|---|
| $0 < \text{Inf\_Num} \leq 21$ | 648 |
| $21 < \text{Inf\_Num} \leq 44$ | 1296 |
| $44 < \text{Inf\_Num} \leq 121$ | 1944 |
| $121 < \text{Inf\_Num} \leq 162$ | If $R \leq R_{th}$, 1296; or if $R > R_{th}$, 1944 |
| $162 < \text{Inf\_Num}$ | 1944 |

**Table 16**

| Length range of the to-be-encoded information bit (range (bytes) of Inf_Num) | LDPC code word length (LDPC code word length in bits ($L_{LDPC}$)) |
|---|---|
| $0 < Inf\_Num \leq 21$ | 648 |
| $21 < Inf\_Num \leq 44$ | 1296 |
| $44 < Inf\_Num \leq 121$ | 1944 |
| $121 < Inf\_Num \leq 162$ | If $R \leq Rth$, 1296; or if $R > Rth$, 1944 |
| $162 < Inf\_Num \leq 202$ | 648 |
| $202 < Inf\_Num \leq 243$ | 1944 |
| $243 < Inf\_Num \leq 324$ | 1296 |
| $324 < Inf\_Num$ | 1944 |

Optionally, a reference bit rate R of the LDPC code word is 1/2.

Optionally, after step S302, the communication apparatus may generate the LDPC code word based on the determined length of the LDPC code word, the to-be-encoded information bit, the reference bit rate (1/2) of the LDPC code word, and other information, and transmit the LDPC code word. The LDPC code word includes the to-be-encoded information bit and the parity bit generated by encoding the to-be-encoded information bit (or the to-be-encoded information bit and a shortening zero bit) by using the parity-check matrix corresponding to the LDPC code word. For example, for a manner of generating the LDPC code word by the communication apparatus, refer to step 1 to step 4 in FIG. 5. For example, the communication apparatus may transmit the LDPC code word to another communication apparatus, or transmit the LDPC code word to a next module of the channel coding module for processing. For example, for a manner of transmitting the LDPC code word by the communication apparatus, refer to step 6 in FIG. 5. In other words, because the UWB system does not include an OFDM symbol, an LDPC encoding process in the UWB system does not include step 5 in FIG. 5.

In this embodiment of this application, a quantity of shortening zero bits in the LDPC code word may be determined based on the length of the to-be-encoded information bit and a quantity of information bits in the LDPC code word. The quantity of information bits in the LDPC code word is determined based on the length of the LDPC code word and the reference bit rate. Specifically, the quantity of shortening zero bits is determined based on the formula (2-1).

For beneficial effect of this embodiment of this application, refer to the beneficial effect of Embodiment 1 or Embodiment 2. Details are not described herein again.

The foregoing content describes in detail the method provided in this application. To facilitate implementation of the foregoing solutions in embodiments of this application, embodiments of this application further provide a corresponding apparatus or device.

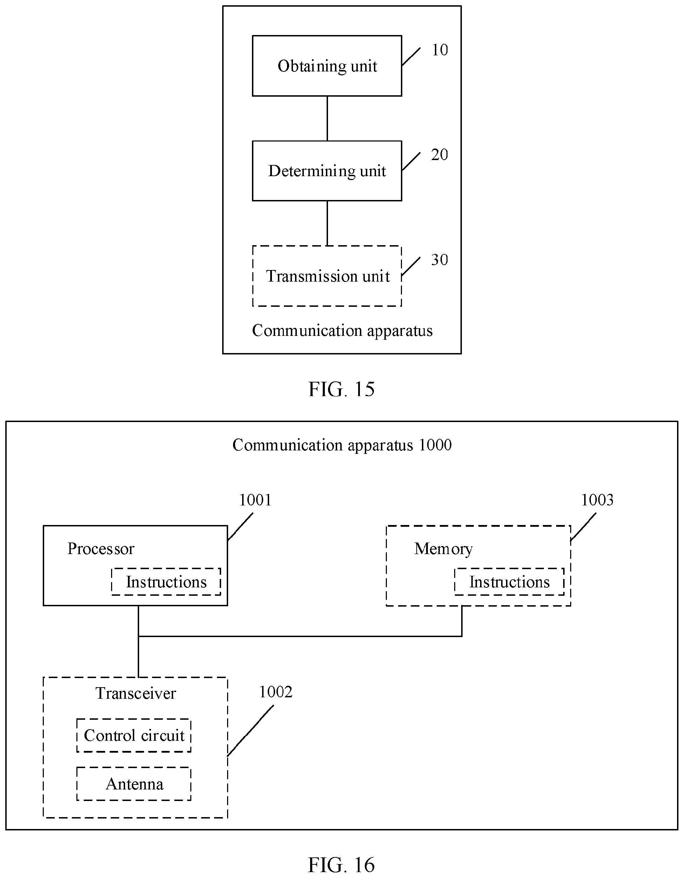

In this application, a communication apparatus is divided into functional modules based on the method embodiments. For example, the functional modules may be divided based on functions, or at least two functions may be integrated into one processing module. The integrated module may be implemented in a form of hardware, or may be implemented in a form of a software functional module. It should be noted that, in this application, division into the modules is an example and is merely logical function division. In actual implementation, another division manner may be used. The following describes in detail a communication apparatus in embodiments of this application with reference to FIG. 15 to FIG. 17.

FIG. 15 is a diagram of a structure of a communication apparatus according to an embodiment of this application. As shown in FIG. 15, the communication apparatus includes an obtaining unit 10 and a determining unit 20. Optionally, the communication apparatus further includes a transmission unit 30.

In a design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 1944 bits. If the length of the to-be-encoded information bit is greater than 972 bits and less than or equal to 1296 bits, the length of the LDPC code word is 1296 bits.

In a possible implementation, the transmission unit 30 is configured to transmit the LDPC code word, where the LDPC code word includes the to-be-encoded information bit and the parity bit.

In another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 648 bits.

In a possible implementation, the transmission unit 30 is configured to transmit the LDPC code word, where the LDPC code word includes the to-be-encoded information bit and the parity bit.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than or equal to 41 bytes and less than or equal to 81 bytes, the length of the LDPC code word is 1296 bits. If the length of the to-be-encoded information bit is greater than or equal to 82 bytes and less than or equal to 121 bytes, the length of the LDPC code word is 1944 bits. If the length of the to-be-encoded information bit is greater than or equal to 122 bytes and less than or equal to 162 bytes, the length of the LDPC code word is 1296 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than or equal to 163 bytes, the length of the LDPC code word is 1944 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions:

If the length of the to-be-encoded information bit is greater than or equal to 163 bytes and less than or equal to 202 bytes, the length of the LDPC code word is 648 bits. If the length of the to-be-encoded information bit is greater than or equal to 203 bytes and less than or equal to 243 bytes, the length of the LDPC code word is 1944 bits. If the length of the to-be-encoded information bit is greater than or equal to 244 bytes and less than or equal to 324 bytes, the length of the LDPC code word is 1296 bits. If the length of the to-be-encoded information bit is greater than or equal to 325 bytes, the length of the LDPC code word is 1944 bits.

In a possible implementation of any one of the foregoing designs, the transmission unit 30 is configured to transmit the LDPC code word, where the LDPC code word includes the to-be-encoded information bit and the parity bit.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than 40 bytes and less than or equal to 81 bytes, the length of the LDPC code word is 1296 bits. If the length of the to-be-encoded information bit is greater than 81 bytes and less than or equal to 121 bytes, the length of the LDPC code word is 1944 bits. If the length of the to-be-encoded information bit is greater than 121 bytes and less than or equal to 162 bytes, the length of the LDPC code word is 1296 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than 162 bytes, the length of the LDPC code word is 1944 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions:

If the length of the to-be-encoded information bit is greater than 162 bytes and less than or equal to 202 bytes, the length of the LDPC code word is 648 bits. If the length of the to-be-encoded information bit is greater than 202 bytes and less than or equal to 243 bytes, the length of the LDPC code word is 1944 bits. If the length of the to-be-encoded information bit is greater than 243 bytes and less than or equal to 324 bytes, the length of the LDPC code word is 1296 bits. If the length of the to-be-encoded information bit is greater than 324 bytes, the length of the LDPC code word is 1944 bits.

In a possible implementation of any one of the foregoing designs, the transmission unit 30 is configured to transmit the LDPC code word, where the LDPC code word includes the to-be-encoded information bit and the parity bit.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than or equal to 41 bytes and less than or equal to 81 bytes, the length of the LDPC code word is 1296 bits. If the length of the to-be-encoded information bit is greater than or equal to 82 bytes and less than or equal to 121 bytes, the length of the LDPC code word is 648 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than or equal to 122 bytes, the length of the LDPC code word is 1296 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions:

If the length of the to-be-encoded information bit is greater than or equal to 122 bytes and less than or equal to 162 bytes, the length of the LDPC code word is 1296 bits. If the length of the to-be-encoded information bit is greater than or equal to 163 bytes and less than or equal to 202 bytes, the length of the LDPC code word is 648 bits. If the length of the to-be-encoded information bit is greater than or equal to 203 bytes, the length of the LDPC code word is 1296 bits.

In a possible implementation of any one of the foregoing designs, the transmission unit 30 is configured to transmit the LDPC code word, where the LDPC code word includes the to-be-encoded information bit and the parity bit.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions: If the length of the to-be-encoded information bit is greater than 0 and less than or equal to 40 bytes, the length of the LDPC code word is 648 bits. If the length of the to-be-encoded information bit is greater than 40 bytes and less than or equal to 81 bytes, the length of the LDPC code word is 1296 bits. If the length of the to-be-encoded information bit is greater than 81 bytes and less than or equal to 121 bytes, the length of the LDPC code word is 648 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. If the length of the to-be-encoded information bit is greater than 121 bytes, the length of the LDPC code word is 1296 bits.

In still another design, the obtaining unit 10 is configured to obtain a length of a to-be-encoded information bit; and the determining unit 20 is configured to determine a length of an LDPC code word based on the length of the to-be-encoded information bit, where a parity-check matrix corresponding to the LDPC code word is used to encode the to-be-encoded information bit to generate a parity bit. The length of the to-be-encoded information bit and the length of the LDPC code word meet one or more of the following conditions:

If the length of the to-be-encoded information bit is greater than 121 bytes and less than or equal to 162 bytes, the length of the LDPC code word is 1296 bits. If the length of the to-be-encoded information bit is greater than 162 bytes and less than or equal to 202 bytes, the length of the LDPC code word is 648 bits. If the length of the to-be-encoded information bit is greater than 202 bytes, the length of the LDPC code word is 1296 bits.

In a possible implementation of any one of the foregoing designs, the transmission unit 30 is configured to transmit the LDPC code word, where the LDPC code word includes the to-be-encoded information bit and the parity bit.

The obtaining unit 10, the determining unit 20, and the transmission unit 30 may be integrated into one unit or module, for example, a processing unit. Optionally, the transmission unit 30 may be a transceiver, a transceiver unit, or the like.

It should be understood that, for specific functions of or steps performed by the foregoing units, reference may be made to the method embodiments. Details are not described herein again.

The foregoing describes the communication apparatus in embodiments of this application. The following describes a possible product form of the communication apparatus. It should be understood that a product in any form that has a function of the communication apparatus in FIG. 15 falls within the protection scope of embodiments of this application. It should be further understood that the following descriptions are merely examples, and a product form of the communication apparatus in embodiments of this application is not limited thereto.

In the communication apparatus shown in FIG. 15, the obtaining unit 10, the determining unit 20, and the transmission unit 30 may be implemented by using one or more processors. FIG. 16 is a diagram of a structure of a communication apparatus 1000 according to an embodiment of this application. FIG. 16 shows only main components in the communication apparatus 1000. In addition to a processor 1001, the communication apparatus may further include a transceiver 1002, a memory 1003, and an input/output apparatus (not shown in the figure). The processor 1001 and the transceiver 1002 may be coupled to each other, or the like. A manner of connection between the processor and the transceiver is not limited in this embodiment of this application.

The processor 1001 is mainly configured to process a communication protocol and communication data, control the entire communication apparatus, execute a software program, and process data of the software program. The memory 1003 is mainly configured to store the software program and data. The transceiver 1002 may include a control circuit and an antenna. The control circuit is mainly configured to perform conversion between a baseband signal and a radio frequency signal, and process the radio frequency signal. The antenna is mainly configured to send and receive a radio frequency signal in a form of an electromagnetic wave. The input/output apparatus, such as a touchscreen, a display, or a keyboard, is mainly configured to receive data entered by a user and output data to the user.

After the communication apparatus is powered on, the processor 1001 may read the software program in the memory 1003, interpret and execute instructions of the software program, and process the data of the software program. When data needs to be sent wirelessly, the processor 1001 performs baseband processing on the to-be-sent data, and outputs a baseband signal to a radio frequency circuit. The radio frequency circuit performs radio frequency processing on the baseband signal, and then sends a radio frequency signal to the outside through the antenna in a form of an electromagnetic wave. When data is sent to the communication apparatus, the radio frequency circuit receives a radio frequency signal through the antenna, converts the radio frequency signal into a baseband signal, and outputs the baseband signal to the processor 1001. The processor 1001 converts the baseband signal into data, and processes the data.

In another implementation, the radio frequency circuit and the antenna may be disposed independent of the processor for performing baseband processing. For example, in a distributed scenario, the radio frequency circuit and the antenna may be remotely disposed independent of the communication apparatus.

The processor 1001, the transceiver 1002, and the memory 1003 may be connected through a communication bus.

In a design, the communication apparatus 1000 may be configured to perform the functions in Embodiment 1: The processor 1001 may be configured to perform step S101 and step S102 in FIG. 7, and/or configured to perform another process of the technology described in this specification. The transceiver 1002 may be configured to send and receive information, data, or the like needed in FIG. 7, and/or configured to perform another process of the technology described in this specification.

In another design, the communication apparatus 1000 may be configured to perform the functions in Embodiment 2: The processor 1001 may be configured to perform step S201 and step S202 in FIG. 12, and/or configured to perform another process of the technology described in this specification. The transceiver 1002 may be configured to send and receive information, data, or the like needed in FIG. 12, and/or configured to perform another process of the technology described in this specification.

In still another design, the communication apparatus 1000 may be configured to perform the functions in Embodiment 3: The processor 1001 may be configured to perform step S301 and step S302 in FIG. 14, and/or configured to perform another process of the technology described in this specification. The transceiver 1002 may be configured to send and receive information, data, or the like needed in FIG. 14, and/or configured to perform another process of the technology described in this specification.

In any one of the foregoing designs, the processor 1001 may include a transceiver for implementing sending and receiving functions. For example, the transceiver may be a transceiver circuit, an interface, or an interface circuit. The transceiver circuit, the interface, or the interface circuit for implementing the sending and receiving functions may be separated, or may be integrated together. The transceiver circuit, the interface, or the interface circuit may be configured to read and write code or data. Alternatively, the transceiver circuit, the interface, or the interface circuit may be configured to transmit or transfer a signal.

In any one of the foregoing designs, the processor 1001 may store instructions. The instructions may be a computer program. The computer program is run on the processor 1001, so that the communication apparatus 1000 performs the method described in the method embodiments. The computer program may be fixed in the processor 1001. In this case, the processor 1001 may be implemented by using hardware.

In an implementation, the communication apparatus 1000 may include a circuit. The circuit may implement the sending, receiving, or communication function in the method embodiments. The processor and the transceiver described in this application may be implemented in an integrated circuit (integrated circuit, IC), an analog IC, a radio frequency integrated circuit (radio frequency integrated circuit, RFIC), a mixed-signal IC, an application-specific integrated circuit (application-specific integrated circuit, ASIC), a printed circuit board (printed circuit board, PCB), an electronic device, or the like. The processor and the transceiver may alternatively be manufactured by using various IC process technologies, for example, a complementary metal-oxide-semiconductor (complementary metal-oxide-semiconductor, CMOS), an N-channel metal-oxide-semiconductor (nMetal-oxide-semiconductor, NMOS), a P-channel metal-oxide-semiconductor (positive-channel metal-oxide-semiconductor, PMOS), a bipolar junction transistor (bipolar junction transistor, BJT), a bipolar CMOS (BiCMOS), silicon germanium (SiGe), and gallium arsenide (GaAs).

A scope of the communication apparatus described in this application is not limited thereto, and a structure of the communication apparatus may not be limited by FIG. 16. The communication apparatus may be an independent device, or may be a part of a large device. For example, the communication apparatus may be:

(1) an independent integrated circuit IC, a chip, or a chip system or subsystem;
(2) a set including one or more ICs, where optionally, the set of ICs may also include a storage component for storing data and a computer program;
(3) an ASIC, for example, a modem (Modem);
(4) a module that can be embedded in another device;
(5) a receiver, a terminal, an intelligent terminal, a cellular phone, a wireless device, a handheld device, a mobile unit, a vehicle-mounted device, a network device, a cloud device, an artificial intelligence device, or the like; or
(6) others.

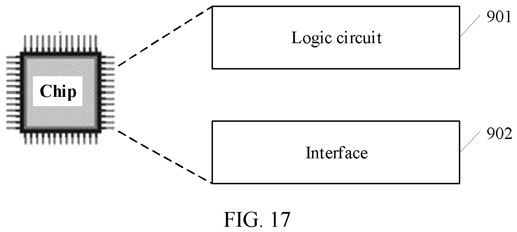

In another possible implementation, in the communication apparatus shown in FIG. 15, the obtaining unit 10 and the determining unit 20 may be implemented by using one or more logic circuits, and the transmission unit 30 may be an input/output interface, also referred to as a communication interface, an interface circuit, an interface, or the like. Alternatively, the transmission unit 30 may be a sending unit and a receiving unit. The sending unit may be an output interface, and the receiving unit may be an input interface. The sending unit and the receiving unit are integrated into one unit, for example, an input/output interface. FIG. 17 is a diagram of another structure of a communication apparatus according to an embodiment of this application. As shown in FIG. 17, the communication apparatus shown in FIG. 17 includes a logic circuit 901 and an interface 902. The logic circuit 901 may be a chip, a processing circuit, an integrated circuit, a system on chip (system on chip, SoC) chip, or the like. The interface 902 may be a communication interface, an input/output interface, a pin, or the like. For example, FIG. 17 shows an example in which the communication apparatus is a chip. The chip includes the logic circuit 901 and the interface 902.

In this embodiment of this application, the logic circuit and the interface may be further coupled to each other. A specific manner of connection between the logic circuit and the interface is not limited in this embodiment of this application.

For example, when the communication apparatus is configured to perform the method, the functions, or the steps performed by the communication apparatus in Embodiment 1, the logic circuit 901 is configured to obtain a length of a to-be-encoded information bit, and determine a length of a low-density parity-check LDPC code word based on the length of the to-be-encoded information bit, where a parity-check matrix corresponding to the LDPC code word is used to encode the to-be-encoded information bit to generate a parity bit; and the interface 902 is configured to output the LDPC code word, where the LDPC code word includes the to-be-encoded information bit and the parity bit. If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 1944 bits. If the length of the to-be-encoded information bit is greater than 972 bits and less than or equal to 1296 bits, the length of the LDPC code word is 1296 bits.

For example, when the communication apparatus is configured to perform the method, the functions, or the steps performed by the communication apparatus in Embodiment 2, the logic circuit 901 is configured to obtain a length of a to-be-encoded information bit, and determine a length of a low-density parity-check LDPC code word based on the length of the to-be-encoded information bit, where a parity-check matrix corresponding to the LDPC code word is used to encode the to-be-encoded information bit to generate a parity bit; and the interface 902 is configured to output the LDPC code word, where the LDPC code word includes the to-be-encoded information bit and the parity bit. If the length of the to-be-encoded information bit is greater than 0 and less than or equal to 324 bits, the length of the LDPC code word is 648 bits. If the length of the to-be-encoded information bit is greater than 324 bits and less than or equal to 648 bits, the length of the LDPC code word is 1296 bits. If the length of the to-be-encoded information bit is greater than 648 bits and less than or equal to 972 bits, the length of the LDPC code word is 648 bits.

For example, when the communication apparatus is configured to perform the method, the functions, or the steps performed by the communication apparatus in Embodiment 3, the logic circuit 901 is configured to obtain a length of a to-be-encoded information bit, and determine a length of a low-density parity-check LDPC code word based on the length of the to-be-encoded information bit, where a parity-check matrix corresponding to the LDPC code word is used to encode the to-be-encoded information bit to generate a parity bit; and the interface 902 is configured to output the LDPC code word, where the LDPC code word includes the to-be-encoded information bit and the parity bit.

It can be understood that the communication apparatus shown in embodiments of this application may implement the method provided in embodiments of this application in a form of hardware, or may implement the method provided in embodiments of this application in a form of software. This is not limited in embodiments of this application.

For specific implementations of embodiments shown in FIG. 17, refer to the foregoing embodiments. Details are not described herein again.

This application further provides a computer program. The computer program is used to implement operations and/or processing performed by the communication apparatus in the method provided in this application.

This application further provides a computer-readable storage medium. The computer-readable storage medium stores computer code. When the computer code is run on a computer, the computer is enabled to perform operations and/or processing performed by the communication apparatus in the method provided in this application.

This application further provides a computer program product. The computer program product includes computer code or a computer program. When the computer code or the computer program is run on a computer, operations and/or processing performed by the communication apparatus in the method provided in this application are performed.

In the several embodiments provided in this application, it should be understood that the disclosed system, apparatus, and method may be implemented in other manners. For example, the described apparatus embodiments are merely examples. For example, division into the units is merely logical function division and may be other division in actual implementation. For example, a plurality of units or components may be combined or integrated into another system, or some features may be ignored or not performed. In addition, the shown or discussed mutual couplings, direct couplings, or communication connections may be implemented through some interfaces. The indirect couplings or communication connections between the apparatuses or units may be implemented in electrical, mechanical, or other forms.

The units described as separate parts may or may not be physically separate, and parts shown as units may or may not be physical units, that is, may be located in one place, or may be distributed on a plurality of network units. Some or all of the units may be selected according to an actual requirement to implement the technical effect of the solutions provided in embodiments of this application.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a computer-readable storage medium. Based on such an understanding, the technical solutions in embodiments of this application essentially, or the part contributing to the conventional technology, or all or some of the technical solutions may be implemented in a form of a software product. The computer software product is stored in a readable storage medium, and includes several instructions for instructing a computer device (which may be a personal computer, a server, a network device, or the like) to perform all or some of the steps of the methods described in embodiments of this application. The readable storage medium includes any medium that can store program code, for example, a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A method for determining a length of a low-density parity-check code word in an ultra-wideband system, comprising:

   obtaining, by a communication apparatus, a length of a to-be-encoded information bit; and

determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

the length of the to-be-encoded information bit and the length of the LDPC code word meet one or more of the following conditions:

if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; if the length of the to-be-encoded information bit is greater than 648 bits and less than or equal to 972 bits, the length of the LDPC code word is 1944 bits; or if the length of the to-be-encoded information bit is greater than 972 bits and less than or equal to 1296 bits, the length of the LDPC code word is 1296 bits.

2. The method according to claim 1, wherein the length of the to-be-encoded information bit and the length of the LDPC code word further meet the following condition: if the length of the to-be-encoded information bit is greater than 1296 bits, the length of the LDPC code word is 1944 bits.

3. The method according to claim 1, wherein the length of the to-be-encoded information bit and the length of the LDPC code word further meet one or more of the following conditions:

if the length of the to-be-encoded information bit is greater than 1296 bits and less than or equal to 1620 bits, the length of the LDPC code word is 648 bits; if the length of the to-be-encoded information bit is greater than 1620 bits and less than or equal to 1944 bits, the length of the LDPC code word is 1944 bits; if the length of the to-be-encoded information bit is greater than 1944 bits and less than or equal to 2592 bits, the length of the LDPC code word is 1296 bits; or if the length of the to-be-encoded information bit is greater than 2592 bits, the length of the LDPC code word is 1944 bits.

4. The method according to any one of claims 1 to 3, wherein the method further comprises:
transmitting, by the communication apparatus, the LDPC code word, wherein the LDPC code word comprises the to-be-encoded information bit and the parity bit.

5. The method according to any one of claims 1 to 4, wherein a reference bit rate of the LDPC code word is 1/2.

6. The method according to any one of claims 1 to 5, wherein a quantity of shortening zero bits in the LDPC code word is determined based on the length of the to-be-encoded information bit and a quantity of information bits in the LDPC code word, and the quantity of information bits in the LDPC code word is determined based on the length of the LDPC code word and the reference bit rate.

7. The method according to claim 5, wherein a quantity of shortening zero bits in the LDPC code word is as follows:

$$\text{Padding\_Num} = \text{mod}(K - \text{mod}(\text{Inf\_Num}, K), K),$$

wherein

Padding_Num indicates the quantity of shortening zero bits in the LDPC code word, K indicates a quantity of information bits in the LDPC code word, Inf_Num indicates the length of the to-be-encoded information bit, and mod indicates a modulo operation;

$$K = N \times R;$$

and
N indicates the length of the LDPC code word, and R indicates the reference bit rate of the LDPC code word.

8. The method according to any one of claims 1 to 7, wherein the to-be-encoded information bit comprises a cyclic redundancy check CRC bit.

9. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

the length of the to-be-encoded information bit and the length of the LDPC code word meet one or more of the following conditions:

if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; or if the length of the to-be-encoded information bit is greater than 648 bits and less than or equal to 972 bits, the length of the LDPC code word is 648 bits.

10. The method according to claim 9, wherein the length of the to-be-encoded information bit and the length of the LDPC code word further meet the following condition: if the length of the to-be-encoded information bit is greater than 972 bits, the length of the LDPC code word is 1296 bits.

11. The method according to claim 9, wherein the length of the to-be-encoded information bit and the length of the LDPC code word further meet one or more of the following conditions:
if the length of the to-be-encoded information bit is greater than 972 bits and less than or equal to 1296 bits, the length of the LDPC code word is 1296 bits; if the length of the to-be-encoded information bit is greater than 1296 bits and less than or equal to 1620 bits, the length of the LDPC code word is 648 bits; or if the length of the to-be-encoded information bit is greater than 1620 bits, the length of the LDPC code word is 1296 bits.

12. The method according to any one of claims 9 to 11, wherein the method further comprises:
transmitting, by the communication apparatus, the LDPC code word, wherein the LDPC code word comprises the to-be-encoded information bit and the parity bit.

13. The method according to any one of claims 9 to 12, wherein a reference bit rate of the LDPC code word is 1/2.

14. The method according to any one of claims 9 to 13, wherein a quantity of shortening zero bits in the LDPC code word is determined based on the length of the to-be-encoded information bit and a quantity of information bits in the LDPC code word, and the quantity of information bits in the LDPC code word is determined based on the length of the LDPC code word and the reference bit rate.

15. The method according to claim 14, wherein a quantity of shortening zero bits in the LDPC code word is as follows:

$$Padding\_Num = mod(K - mod(Inf\_Num, K), K),$$

wherein

Padding_Num indicates the quantity of shortening zero bits in the LDPC code word, K indicates a quantity of information bits in the LDPC code word, Inf_Num indicates the length of the to-be-encoded information bit, and mod indicates a modulo operation;

$$K = N \times R;$$

and
N indicates the length of the LDPC code word, and R indicates the reference bit rate of the LDPC code word.

16. The method according to any one of claims 9 to 15, wherein the to-be-encoded information bit comprises a cyclic redundancy check CRC bit.

17. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:

if the length of the to-be-encoded information bit is greater than 0 and less than or equal to 40 bytes, the length of the LDPC code word is 648 bits; if the length of the to-be-encoded information bit is greater than or equal to 41 bytes and less than or equal to 81 bytes, the length of the LDPC code word is 1296 bits; if the length of the to-be-encoded information bit is greater than or equal to 82 bytes and less than or equal to 121 bytes, the length of the LDPC code word is 1944 bits; or if the length of the to-be-encoded information bit is greater than or equal to 122 bytes and less than or equal to 162 bytes, the length of the LDPC code word is 1296 bits.

18. The method according to claim 17, wherein the length of the to-be-encoded information bit and the length of the LDPC code word further meet the following condition: if the length of the to-be-encoded information bit is greater than or equal to 163 bytes, the length of the LDPC code word is 1944 bits.

19. The method according to claim 17, wherein the length of the to-be-encoded information bit and the length of the LDPC code word further meet one or more of the following conditions:

if the length of the to-be-encoded information bit is greater than or equal to 163 bytes and less than or equal to 202 bytes, the length of the LDPC code word is 648 bits; if the length of the to-be-encoded information bit is greater than or equal to 203 bytes and less than or equal to 243 bytes, the length of the LDPC code word is 1944 bits; if the length of the to-be-encoded information bit is greater than or equal to 244 bytes and less than or equal to 324 bytes, the length of the LDPC code word is 1296 bits; or if the length of the to-be-encoded information bit is greater than or equal to 325 bytes, the length of the LDPC code word is 1944 bits.

20. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
if the length of the to-be-encoded information bit is greater than or equal to 163 bytes, the length of the LDPC code word is 1944 bits.

21. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:
if the length of the to-be-encoded information bit is greater than or equal to 163 bytes and less than or equal to 202 bytes, the length of the LDPC code word is 648 bits; if the length of the to-be-encoded information bit is greater than or equal to 203 bytes and less than or equal to 243 bytes, the length of the LDPC code word is 1944 bits; if the length of the to-be-encoded information bit is greater than or equal to 244 bytes and less than or equal to 324 bytes, the length of the LDPC code word is 1296 bits; or if the length of the to-be-encoded information bit is greater than or equal to 325 bytes, the length of the LDPC code word is 1944 bits.

22. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:
if the length of the to-be-encoded information bit is greater than 0 and less than or equal to 40 bytes, the length of the LDPC code word is 648 bits; if the length of the to-be-encoded information bit is greater than 40 bytes and less than or equal to 81 bytes, the length of the LDPC code word is 1296 bits; if the length of the to-be-encoded information bit is greater than 81 bytes and less than or equal to 121 bytes, the length of the LDPC code word is 1944 bits; or if the length of the to-be-encoded information bit is greater than 121 bytes and less than or equal to 162 bytes, the length of the LDPC code word is 1296 bits.

23. The method according to claim 22, wherein the length of the to-be-encoded information bit and the length of the LDPC code word further meet the following condition: if the length of the to-be-encoded information bit is greater than 162 bytes, the length of the LDPC code word is 1944 bits.

24. The method according to claim 22, wherein the length of the to-be-encoded information bit and the length of the LDPC code word further meet one or more of the following conditions:
if the length of the to-be-encoded information bit is greater than 162 bytes and less than or equal to 202 bytes, the length of the LDPC code word is 648 bits; if the length of the to-be-encoded information bit is greater than 202 bytes and less than or equal to 243 bytes, the length of the LDPC code word is 1944 bits; if the length of the to-be-encoded information bit is greater than 243 bytes and less than or equal to 324 bytes, the length of the LDPC code word is 1296 bits; or if the length of the to-be-encoded information bit is greater than 324 bytes, the length of the LDPC code word is 1944 bits.

25. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
if the length of the to-be-encoded information bit is greater than 162 bytes, the length of the LDPC code word is 1944 bits.

26. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:
if the length of the to-be-encoded information bit is greater than 162 bytes and less than or equal to 202 bytes, the length of the LDPC code word is 648 bits; if the length of the to-be-encoded information bit is greater than 202 bytes and less than or equal to 243 bytes, the length of the LDPC code word is 1944 bits; if the length of the to-be-encoded information bit is greater than 243 bytes and less than or equal to 324 bytes, the length of the LDPC code word is 1296 bits; or if the length of the to-be-encoded information bit is greater than 324 bytes, the length of the LDPC code word is 1944 bits.

27. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:
if the length of the to-be-encoded information bit is greater than 0 and less than or equal to 40 bytes, the length of the LDPC code word is 648 bits; if the length of the to-be-encoded information bit is greater than or equal to 41 bytes and less than or equal to 81 bytes, the length of the LDPC code word is 1296 bits; or if the length of the to-be-encoded information bit is greater than or equal to 82 bytes and less than or equal to 121 bytes, the length of the LDPC code word is 648 bits.

28. The method according to claim 27, wherein the length of the to-be-encoded information bit and the length of the LDPC code word further meet the following condition: if the length of the to-be-encoded information bit is greater than or equal to 122 bytes, the length of the LDPC code word is 1296 bits.

29. The method according to claim 27, wherein the length of the to-be-encoded information bit and the length of the LDPC code word further meet one or more of the following conditions:

if the length of the to-be-encoded information bit is greater than or equal to 122 bytes and less than or equal to 162 bytes, the length of the LDPC code word is 1296 bits; if the length of the to-be-encoded information bit is greater than or equal to 163 bytes and less than or equal to 202 bytes, the length of the LDPC code word is 648 bits; or if the length of the to-be-encoded information bit is greater than or equal to 203 bytes, the length of the LDPC code word is 1296 bits.

30. A method for determining a length of a low-density parity-check code word in an ultra-wideband system, comprising:

obtaining, by a communication apparatus, a length of a to-be-encoded information bit; and

determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

if the length of the to-be-encoded information bit is greater than or equal to 122 bytes, the length of the LDPC code word is 1296 bits.

31. A method for determining a length of a low-density parity-check code word in an ultra-wideband system, comprising:

obtaining, by a communication apparatus, a length of a to-be-encoded information bit; and

determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

the length of the to-be-encoded information bit and the length of the LDPC code word meet one or more of the following conditions:

if the length of the to-be-encoded information bit is greater than or equal to 122 bytes and less than or equal to 162 bytes, the length of the LDPC code word is 1296 bits; if the length of the to-be-encoded information bit is greater than or equal to 163 bytes and less than or equal to 202 bytes, the length of the LDPC code word is 648 bits; or if the length of the to-be-encoded information bit is greater than or equal to 203 bytes, the length of the LDPC code word is 1296 bits.

32. A method for determining a length of a low-density parity-check code word in an ultra-wideband system, comprising:

obtaining, by a communication apparatus, a length of a to-be-encoded information bit; and

determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

the length of the to-be-encoded information bit and the length of the LDPC code word meet one or more of the following conditions:

if the length of the to-be-encoded information bit is greater than 0 and less than or equal to 40 bytes, the length of the LDPC code word is 648 bits; if the length of the to-be-encoded information bit is greater than 40 bytes and less than or equal to 81 bytes, the length of the LDPC code word is 1296 bits; or if the length of the to-be-encoded information bit is greater than 81 bytes and less than or equal to 121 bytes, the length of the LDPC code word is 648 bits.

33. The method according to claim 32, wherein the length of the to-be-encoded information bit and the length of the LDPC code word further meet the following condition: if the length of the to-be-encoded information bit is greater than 121 bytes, the length of the LDPC code word is 1296 bits.

34. The method according to claim 32, wherein the length of the to-be-encoded information bit and the length of the LDPC code word further meet one or more of the following conditions:

if the length of the to-be-encoded information bit is greater than 121 bytes and less than or equal to 162 bytes, the length of the LDPC code word is 1296 bits; if the length of the to-be-encoded information bit is greater than 162 bytes and less than or equal to 202 bytes, the length of the LDPC code word is 648 bits; or if the length of the to-be-encoded information bit is greater than 202 bytes, the length of the LDPC code word is 1296 bits.

35. A method for determining a length of a low-density parity-check code word in an ultra-wideband system, comprising:

obtaining, by a communication apparatus, a length of a to-be-encoded information bit; and

determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein

if the length of the to-be-encoded information bit is greater than 121 bytes, the length of the LDPC code word is 1296 bits.

36. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet one or more of the following conditions:
if the length of the to-be-encoded information bit is greater than 121 bytes and less than or equal to 162 bytes, the length of the LDPC code word is 1296 bits; if the length of the to-be-encoded information bit is greater than 162 bytes and less than or equal to 202 bytes, the length of the LDPC code word is 648 bits; or if the length of the to-be-encoded information bit is greater than 202 bytes, the length of the LDPC code word is 1296 bits.

37. A method for determining a length of a low-density parity-check code word in an ultra-wideband system, comprising:

obtaining, by a communication apparatus, a length of a to-be-encoded information bit; and
determining, by the communication apparatus, a length of a low-density parity-check LDPC code word based on the length of the to-be-encoded information bit, wherein a parity-check matrix corresponding to the LDPC code word is used to encode the to-be-encoded information bit to generate a parity bit, wherein
the length of the to-be-encoded information bit and the length of the LDPC code word meet the following conditions: when the length of the to-be-encoded information bit is greater than 121 bytes and less than or equal to 162 bytes, if a data rate is less than or equal to a preset threshold, the length of the LDPC code word is 1296 bits; or when the length of the to-be-encoded information bit is greater than 121 bytes and less than or equal to 162 bytes, if the data rate is greater than the preset threshold, the length of the LDPC code word is 1944 bits.

38. The method according to claim 37, wherein the length of the to-be-encoded information bit and the length of the LDPC code word further meet the following condition: if the length of the to-be-encoded information bit is greater than 162 bytes, the length of the LDPC code word is 1944 bits.

39. The method according to claim 37 or 38, wherein the preset threshold is 1.95 Mbps or 7.8 Mbps.

40. The method according to claim 37 or 38, wherein the length of the to-be-encoded information bit and the length of the LDPC code word further meet one or more of the following conditions: if the length of the to-be-encoded information bit is greater than 0 and less than or equal to 21 bytes, the length of the LDPC code word is 648 bits; if the length of the to-be-encoded information bit is greater than 21 bytes and less than or equal to 44 bytes, the length of the LDPC code word is 1296 bits; or if the length of the to-be-encoded information bit is greater than 44 bytes and less than or equal to 121 bytes, the length of the LDPC code word is 1944 bits.

41. A communication apparatus, comprising units or modules configured to perform the method according to any one of claims 17 to 40.

42. A communication apparatus, comprising:

an obtaining unit, configured to obtain a length of a to-be-encoded information bit; and
a determining unit, configured to determine a length of a low-density parity-check LDPC code word based on the length of the to-be-encoded information bit, wherein a parity-check matrix corresponding to the LDPC code word is used to encode the to-be-encoded information bit to generate a parity bit, wherein
if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; if the length of the to-be-encoded information bit is greater than 648 bits and less than or equal to 972 bits, the length of the LDPC code word is 1944 bits; or if the length of the to-be-encoded information bit is greater than 972 bits and less than or equal to 1296 bits, the length of the LDPC code word is 1296 bits.

43. The apparatus according to claim 42, wherein if the length of the to-be-encoded information bit is greater than 1296 bits, the length of the LDPC code word is 1944 bits.

44. The apparatus according to claim 42, wherein if the length of the to-be-encoded information bit is greater than 1296 bits and less than or equal to 1620 bits, the length of the LDPC code word is 648 bits; if the length of the to-be-encoded information bit is greater than 1620 bits and less than or equal to 1944 bits, the length of the LDPC code word is 1944 bits; if the length of the to-be-encoded information bit is greater than 1944 bits and less than or equal to 2592 bits, the length of the LDPC code word is 1296 bits; or if the length of the to-be-encoded information bit is greater than 2592 bits, the length of the LDPC code word is 1944 bits.

45. The apparatus according to any one of claims 42 to 44, wherein the apparatus further comprises a transmission unit, configured to transmit the LDPC code word, wherein the LDPC code word comprises the to-be-encoded information bit and the parity bit.

46. A communication apparatus, comprising:

an obtaining unit, configured to obtain a length of a to-be-encoded information bit; and
a determining unit, configured to determine a length of a low-density parity-check LDPC code word based on the length of the to-be-encoded information bit, wherein a parity-check matrix corresponding to the LDPC code word is used to encode the to-be-encoded information bit to generate a parity bit, wherein
if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; or if the length of the to-be-encoded information bit is greater than 648 bits and less than or equal to 972 bits, the length of the LDPC code word is 648 bits.

47. The apparatus according to claim 46, wherein if the length of the to-be-encoded information bit is greater than 972 bits, the length of the LDPC code word is 1296 bits.

48. The apparatus according to claim 46, wherein if the length of the to-be-encoded information bit is greater than 972 bits and less than or equal to 1296 bits, the length of the LDPC code word is 1296 bits; if the length of the to-be-encoded information bit is greater than 1296 bits and less than or equal to 1620 bits, the length of the LDPC code word is 648 bits; or if the length of the to-be-encoded information bit is greater than 1620 bits, the length of the LDPC code word is 1296 bits.

49. The apparatus according to any one of claims 46 to 48, wherein the apparatus further comprises a transmission unit, configured to transmit the LDPC code word, wherein the LDPC code word comprises the to-be-encoded information bit and the parity bit.

50. A communication apparatus, comprising a processor and a memory, wherein

the memory is configured to store instructions; and
the processor is configured to execute the instructions, to enable the method according to any one of claims 1 to 40 to be performed.

51. A communication apparatus, comprising a logic circuit and an interface, wherein the logic circuit is coupled to the interface; and
the interface is configured to input and/or output code instructions, and the logic circuit is configured to execute the code instructions, to enable the method according to any one of claims 1 to 40 to be performed.

52. A computer-readable storage medium, wherein the computer-readable storage medium is configured to store a computer program, and when the computer program is executed, the method according to any one of claims 1 to 40 is performed.

PAN coordinator

● Full function device

○ Reduced function device

FIG. 1

● Full function device

PAN coordinator

○ Reduced function device

FIG. 2

$$\mathbf{H} = \begin{array}{c} \phantom{V_1}\begin{matrix} V_1 & V_2 & V_3 & V_4 & V_5 & V_6 & V_7 & V_8 \end{matrix} \\ \begin{bmatrix} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 1 & 0 & 1 & 1 & 0 & 0 & 1 \end{bmatrix} \begin{matrix} C_1 \\ C_2 \\ C_3 \\ C_4 \end{matrix} \end{array}$$

FIG. 3a

FIG. 3b

```
0   -   -   -   0   0   -   -   0   -   -   0   1   0   -   -   -   -   -   -   -   -   -   -
22  0   -   -   17  -   0   0   12  -   -   -   -   0   0   -   -   -   -   -   -   -   -   -
6   -   0   -   10  -   -   -   24  -   0   -   -   -   0   0   -   -   -   -   -   -   -   -
2   -   -   0   20  -   -   -   25  0   -   -   -   -   -   0   0   -   -   -   -   -   -   -
23  -   -   -   3   -   -   -   0   -   9   11  -   -   -   -   0   0   -   -   -   -   -   -
24  -   23  1   17  -   3   -   10  -   -   -   -   -   -   -   -   0   0   -   -   -   -   -
25  -   -   -   8   -   -   -   7   18  -   -   0   -   -   -   -   -   0   0   -   -   -   -
13  24  -   -   0   -   8   -   6   -   -   -   -   -   -   -   -   -   -   0   0   -   -   -
7   20  -   16  22  10  -   -   23  -   -   -   -   -   -   -   -   -   -   -   0   0   -   -
11  -   -   -   19  -   -   -   13  -   3   17  -   -   -   -   -   -   -   -   -   0   0   -
25  -   8   -   23  18  -   14  9   -   -   -   -   -   -   -   -   -   -   -   -   -   0   0
3   -   -   -   16  -   -   2   25  5   -   -   1   -   -   -   -   -   -   -   -   -   -   0
```

FIG. 4a

$$\begin{bmatrix} 0 & 1 & 0 & \ldots & 0 \\ 0 & 0 & 1 & \ldots & 1 \\ \vdots & \vdots & \vdots & \ddots & \vdots \\ 0 & 0 & 0 & \ldots & 0 \\ 1 & 0 & 0 & \ldots & 1 \end{bmatrix}$$

FIG. 4b

Step 1 | Payload bits

# of code
words and
Step 2 code word size | LDPC code word | LDPC code word | LDPC code word

Step 3 Shortening | Payload bits | Shortening zero bits | | Payload bits | Shortening zero bits | | Payload bits | Shortening zero bits |

Step 4 Parity | Payload bits | Shortening zero bits | Parity bits | Payload bits | Shortening zero bits | Parity bits | Payload bits | Shortening zero bits | Parity bits

Discard shortening bits | Payload bits | Parity bits | Payload bits | Parity bits | Payload bits | Parity bits

Step 5 Repetition | Payload bits | Parity bits | Repeat bits | Payload bits | Parity bits | Repeat bits | Payload bits | Parity bits | Repeat bits

Or

Puncturing | Payload bits | Parity bits | Payload bits | Parity bits | Payload bits | Parity bits

Step 6 Concatenation | Code word | Code word | Code word

Stream parsing

Stream 1

...

Stream N$_{ss}$

Payload bits: payload bits  LDPC code word: LDPC code word
Shortening zero bits: shortening zero bits
Shortening: shortening
Parity: parity     Parity bits: parity bits     Step: step
Discard shortening bits: discard shortening bits
Repeat bits: repeated bits     Repetition: repetition
Puncturing: puncturing
Code word: code word          Concatenation: concatenation
Stream parsing: stream parsing       Stream: stream

FIG. 5

40

```
40 -  -  -  22 -  49 23 43 -  -  -  1  0  -  -  -  -  -  -  -  -  -  -  -
50 1  -  -  48 35 -  -  13 -  30 -  -  0  0  -  -  -  -  -  -  -  -  -  -
39 50 -  -  4  -  2  -  -  -  -  49 -  -  0  0  -  -  -  -  -  -  -  -  -
33 -  -  38 37 -  -  4  1  -  -  -  -  -  0  0  -  -  -  -  -  -  -  -  -
45 -  -  -  0  22 -  -  20 42 -  -  -  -  -  -  0  0  -  -  -  -  -  -  -
51 -  -  48 35 -  -  -  44 -  18 -  -  -  -  -  -  0  0  -  -  -  -  -  -
47 11 -  -  -  17 -  -  51 -  -  -  0  -  -  -  -  -  0  0  -  -  -  -  -
5  -  25 -  6  -  45 -  13 40 -  -  -  -  -  -  -  -  -  0  0  -  -  -  -
33 -  -  34 24 -  -  -  23 -  -  46 -  -  -  -  -  -  -  -  0  0  -  -  -
1  -  27 -  1  -  -  -  38 -  44 -  -  -  -  -  -  -  -  -  -  0  0  -  -
-  18 -  -  23 -  -  8  0  35 -  -  -  -  -  -  -  -  -  -  -  -  0  0
49 -  17 -  30 -  -  -  34 -  -  19 1  -  -  -  -  -  -  -  -  -  -  -  0
```

FIG. 6a

```
57 -  -  -  50 -  11 -  50 -  79 -  1  0  -  -  -  -  -  -  -  -  -  -  -
3  -  28 -  0  -  -  -  55 7  -  -  -  0  0  -  -  -  -  -  -  -  -  -
30 -  -  -  24 37 -  -  56 14 -  -  -  -  0  0  -  -  -  -  -  -  -  -  -
62 53 -  -  53 -  -  3  35 -  -  -  -  -  0  0  -  -  -  -  -  -  -  -  -
40 -  -  20 66 -  -  22 28 -  -  -  -  -  -  0  0  -  -  -  -  -  -  -  -
0  -  -  -  8  -  42 -  50 -  -  8  -  -  -  -  0  0  -  -  -  -  -  -  -
69 79 79 -  -  -  56 -  52 -  -  -  0  -  -  -  -  -  0  0  -  -  -  -  -
65 -  -  -  38 57 -  -  72 -  27 -  -  -  -  -  -  -  0  0  -  -  -  -
64 -  -  -  14 52 -  -  30 -  -  32 -  -  -  -  -  -  -  0  0  -  -  -
-  45 -  70 0  -  -  -  77 9  -  -  -  -  -  -  -  -  -  -  0  0  -  -
2  56 -  57 35 -  -  -  -  -  12 -  -  -  -  -  -  -  -  -  -  -  0  0
24 -  61 -  60 -  -  27 51 -  -  16 1  -  -  -  -  -  -  -  -  -  -  0
```

FIG. 6b

S101

A communication apparatus obtains a length of a to-be-encoded information bit

The communication apparatus determines a length of an LDPC code word based on the length of the to-be-encoded information bit, where a parity-check matrix corresponding to the LDPC code word is used to encode the to-be-encoded information bit to generate a parity bit; and if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; if the length of the to-be-encoded information bit is greater than 648 bits and less than or equal to 972 bits, the length of the LDPC code word is 1944 bits; or if the length of the to-be-encoded information bit is greater than 972 bits and less than or equal to 1296 bits, the length of the LDPC code word is 1296 bits

S102

FIG. 7

Step 1

| Payload bits |
|---|

Step 2 | # of code words and code word size

| LDPC code word | LDPC code word | LDPC code word |
|---|---|---|

Step 3 | Shortening

| Payload bits | Shortening zero bits | | Payload bits | Shortening zero bits | | Payload bits | Shortening zero bits | |
|---|---|---|---|---|---|---|---|---|

Step 4 | Parity

| Payload bits | Shortening zero bits | Parity bits | Payload bits | Shortening zero bits | Parity bits | Payload bits | Shortening zero bits | Parity bits |
|---|---|---|---|---|---|---|---|---|

Discard shortening bits

| Payload bits | Parity bits | Payload bits | Parity bits | Payload bits | Parity bits |
|---|---|---|---|---|---|

Payload bits: payload bits    LDPC code word: LDPC code word
Shortening zero bits: shortening zero bits    Shortening: shortening
Parity: parity    Parity bits: parity bits    Step: step
Discard shortening bits: discard shortening bits

FIG. 8

FIG. 9

FIG. 10

FIG. 11a

FIG. 11b

A communication apparatus obtains a length of a to-be-encoded information bit | S201

The communication apparatus determines a length of an LDPC code word based on the length of the to-be-encoded information bit, where a parity-check matrix corresponding to the LDPC code word is used to encode the to-be-encoded information bit to generate a parity bit; and if the length of the to-be-encoded information bit is greater than 0 and less than or equal to 324 bits, the length of the LDPC code word is 648 bits; if the length of the to-be-encoded information bit is greater than 324 bits and less than or equal to 648 bits, the length of the LDPC code word is 1296 bits; or if the length of the to-be-encoded information bit is greater than 648 bits and less than or equal to 972 bits, the length of the LDPC code word is 648 bits | S202

FIG. 12

Threshold
Rth = 0.4

FIG. 13a

FIG. 13b

FIG. 14

FIG. 15

FIG. 16

Chip

Logic circuit — 901

Interface — 902

FIG. 17

## INTERNATIONAL SEARCH REPORT

| International application No. |
|---|
| **PCT/CN2023/102418** |

| A. | CLASSIFICATION OF SUBJECT MATTER |
|---|---|

H04L1/00(2006.01)i

According to International Patent Classification (IPC) or to both national classification and IPC

| B. | FIELDS SEARCHED |
|---|---|

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNABS, CNTXT, CNKI, VEN, EXTXT, ENTXTC, 3GPP: 低密度奇偶校验, 校验矩阵, 比特, 长度, 长于, 大于, 短于, 少于, 码字, LDPC, check matrix, bit, length, longer, more, shorter, less, codeword, 1296, 1944, 648, 324, 972

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 107733439 A (CHINA ACADEMY OF TELECOMMUNICATIONS TECHNOLOGY) 23 February 2018 (2018-02-23) description, paragraphs [0175]-[0186] | 20, 25, 30, 35, 41, 50-52 |
| Y | CN 110249537 A (IDAC HOLDINGS, INC.) 17 September 2019 (2019-09-17) description, paragraphs [0092]-[0125] | 20, 25, 30, 35, 41, 50-52 |
| A | CN 110289933 A (HUAWEI TECHNOLOGIES CO., LTD.) 27 September 2019 (2019-09-27) entire document | 1-52 |
| A | US 2020235759 A1 (IDAC HOLDINGS INC.) 23 July 2020 (2020-07-23) entire document | 1-52 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 September 2023** | **21 September 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**EP 4 539 370 A1**

International application No.

**PCT/CN2023/102418**

| Patent document cited in search report | | | Publication date (day/month/year) | Patent family member(s) | | | Publication date (day/month/year) |
|---|---|---|---|---|---|---|---|
| CN | 107733439 | A | 23 February 2018 | WO | 2018028469 | A1 | 15 February 2018 |
| CN | 110249537 | A | 17 September 2019 | US | 2021384922 | A1 | 09 December 2021 |
| | | | | EP | 3577764 | A1 | 11 December 2019 |
| | | | | JP | 2020511030 | A | 09 April 2020 |
| | | | | JP | 7075409 | B2 | 25 May 2022 |
| | | | | BR | 112019016156 | A2 | 24 March 2020 |
| | | | | KR | 20230079251 | A | 05 June 2023 |
| | | | | US | 2020235759 | A1 | 23 July 2020 |
| | | | | US | 11038540 | B2 | 15 June 2021 |
| | | | | RU | 2720950 | C1 | 15 May 2020 |
| | | | | TW | 201841485 | A | 16 November 2018 |
| | | | | TWI | 685237 | B | 11 February 2020 |
| | | | | WO | 2018144560 | A1 | 09 August 2018 |
| | | | | KR | 20190119036 | A | 21 October 2019 |
| | | | | KR | 102539912 | B1 | 02 June 2023 |
| CN | 110289933 | A | 27 September 2019 | WO | 2019179404 | A1 | 26 September 2019 |
| US | 2020235759 | A1 | 23 July 2020 | None | | | |

Form PCT/ISA/210 (patent family annex) (July 2022)

51

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210769913
- CN 202211274829
- CN 202211289383X
- CN 202310305051